# EUROPÄISCHE PATENTSCHRIFT

(11) **EP 2 745 277 B1**
(45) Veröffentlichungstag und Bekanntmachung des Hinweises auf die Patenterteilung: **19.09.2018**
(21) Anmeldenummer: 12766873.9
(22) Anmeldetag: 15.08.2012
(51) Int. Cl.: G07D 7/04

(54) **MESSVORRICHTUNG ZUM MESSEN MAGNETISCHER EIGENSCHAFTEN DER UMGEBUNG DER MESSVORRICHTUNG**
MEASURING DEVICE FOR MEASURING THE MAGNETIC PROPERTIES OF THE SURROUNDINGS OF THE MEASURING DEVICE
DISPOSITIF DE MESURE POUR MESURER DES PROPRIÉTÉS MAGNÉTIQUES DE L'ENVIRONNEMENT DU DISPOSITIF DE MESURE

(30) Priorität: 15.08.2011 DE 102011110138
(43) Veröffentlichungstag der Anmeldung: 25.06.2014
(73) Patentinhaber: TE Connectivity Sensors Germany GmbH, 44227 Dortmund (DE)
(72) Erfinder: BARTOS, Axel, 45731 Waltrop (DE); MEISENBERG, Armin, 44227 Dortmund (DE); PIEPER, Reinhold, 59348 Lüdinghausen (DE)
(74) Vertreter: Tilmann, Max Wilhelm
(86) Internationale Anmeldenummer: PCT/EP2012/003469
(87) Internationale Veröffentlichungsnummer: WO 2013/023781

(56) Entgegenhaltungen:
- DE-A1- 19 625 224
- DE-A1-102005 008 967
- DE-A1-102008 033 579
- DE-A1-102008 061 507

## Beschreibung

Die Erfindung betrifft eine Messvorrichtung zum Messen magnetischer Eigenschaften der Umgebung der Messvorrichtung.

Ein mögliches Anwendungsgebiet der Erfindung ist das Prüfen von Scheinen oder Bögen, insbesondere von Geldscheinen, Schecks oder anderen Papierbögen auf das Vorhandensein magnetischer Merkmale, insbesondere daraufhin, ob die Scheine oder Bögen besondere, vorher festgelegte magnetische Merkmale aufweisen.

Das Volumen der auf einem Wertdokument verwendeten magnetischen Materialien ist in der Regel gering. Das magnetische Streufeld des Sicherheitsfadens beträgt deshalb in einem Abstand von wenigen mm von dem Sicherheitsfaden lediglich einige wenige A/m. Für den Nachweis derartig geringer magnetischer Streufelder sind sehr empfindliche Sensoren notwendig. Die in der Praxis eingesetzten Messvorrichtungen benötigen deshalb einen Abstand zwischen Wertdokument und Sensor, der nicht mehr als 1 mm beträgt. Zudem sind für die Erkennung derart schwacher, lokal begrenzter Streufelder nur wenige Technologien geeignet. Bekannt ist unter anderem der Einsatz von planaren Differentialspulen (DE 37 38 455 A1), magnetoresistive Sensorelemente (GB 1 362 105) sowie die Technologien, die für Leseköpfe oder Feldplatten eingesetzt werden, wie beispielsweise aus DE 39 21 420 A1 bekannt. Die in den in der Praxis eingesetzten Messvorrichtungen verwendeten Sensoren werden häufig als mehrkanalige Zeilen ausgeführt (DE 38 51 078 T2, DE 39 16 978 A1 und DE 690 06 529 T2) oder als magnetoresistive Sensoren (DE 692 23 721 T2).

Wertdokumente können weichmagnetische Sicherheitsmerkmale und/oder hartmagnetische Sicherheitsmerkmale aufweisen. Hartmagnetische Sicherheitsmerkmale können aus Werkstoffen mit hoher Remanenz und hoher Koerzitivfeldstärke hergestellt werden. Weichmagnetische Sicherheitsmerkmale können aus Werkstoffen mit hoher Remanenz aber geringer Koerzitivfeldstärke hergestellt werden. Permanentmagneten sind insbesondere aus hartmagnetischen Werkstoffen hergestellt. Weichmagnetische Werkstoffe sind ferromagnetische Materialien, die sich in einem Magnetfeld leicht magnetisieren lassen. Die damit verbundene magnetische Polarisation (Magnetisierung) kann z. B. durch einen elektrischen Strom in einer stromdurchflossenen Spule oder durch Anwesenheit eines Permanentmagneten erzeugt werden. Eine so erzeugte Polarisation führt in dem weichmagnetischen Werkstoff zu einer vielfach höheren magnetischen Flussdichte als das von außen wirkende magnetische Feld in der Luft erzeugt. Weichmagnetische Werkstoffe besitzen in der Regel eine Koerzitivfeldstärke von weniger als 1000 A/m. Weichmagnetische Werkstoffe können allerdings durchaus zu hartmagnetischen Werkstoffen vergleichbare Sättigungsmagnetisierungswerte besitzen, sodass sie im gesättigten Zustand von hartmagnetischen Materialien nicht zu unterscheiden sind.

Zum Nachweis weichmagnetischer Sicherheitsmerkmale in einem Wertdokument muss daher ein externes Magnetfeld vorhanden sein, das die weichmagnetischen Stoffe möglichst sättigt. In aus der Praxis bekannten Messvorrichtungen werden große Magnete verbaut, die ein genügend starkes Feld zur Magnetisierung der weich- und hartmagnetischen Sicherheitsmerkmale erzeugen, aber auch den Aufbau derartiger Messvorrichtungen kompliziert machen. Aus DE 696 08 137 T2 ist es bekannt, einen Lesekopf bereitzustellen, der Magnetisierungsmittel und mindestens ein magnetoresistives Element aufweist, wobei das magnetoresistive Element einen variablen Widerstand hat, der vom an ihn angebrachten magnetischen Fluss abhängig ist. Der dort beschriebene Lesekopf wird derart eingesetzt, dass jedes zu erkennende Wertdokument während der Relativbewegung des Wertdokuments zum Lesekopf zunächst vor dem Magnetisierungsmittel und dann vor besagten magnetoresistiven Element vorbeigeführt wird, wobei das Magnetisierungsmittel so ausgelegt sein kann, dass ein ständiger magnetischer Fluss am Sensorelement anliegt.

Von hartmagnetischen Sicherheitsmerkmalen geht von sich aus und ohne Anwesenheit eines externen Magnetfelds ein Magnetfeld aus, sofern die hartmagnetischen Materialien zuvor vollständig und eindeutig magnetisiert wurden. Dieses Magnetfeld bleibt auch über längere Zeit bestehen. Über die Zeit führen aber statistische Prozesse dazu, dass die hartmagnetischen Materialien entmagnetisiert werden können. Beispielsweise erfahren Geldscheine bei ihrer Handhabung häufig Stöße oder werden geknittert. Dies kann zu einer Entmagnetisierung der hartmagnetischen Materialien führen. Deshalb ist es zum Messen hartmagnetischer Sicherheitsmerkmale zweckmäßig, durch einen Vormagnetisierungsmagneten dem hartmagnetischen Sicherheitsmerkmal eine neue (eindeutige und dauerhafte) Magnetisierung aufzuprägen. Diese neu aufgeprägte Magnetisierung kann das hartmagnetische Sicherheitsmerkmal dann über eine größere Zeitspanne, mindestens über dem Zeitraum der Messung, halten.

Ein besonderes Sicherheitsmerkmal auf Banknoten ist der ferromagnetische Sicherheitsfaden (siehe DE 16 96 245 A1). In der Praxis kommen zur Bildung des Sicherheitsfadens beispielsweise ferromagnetische Materialien zum Einsatz, die aber sowohl eine geringe Koerzitivfeldstärke als auch eine große Koerzitivfeldstärke aufweisen können. Messvorrichtungen zum Prüfen derartiger Banknoten sind in besonders bevorzugter Ausführungsform deshalb dafür ausgelegt, sowohl Sicherheitsfäden aus Material mit geringer, als auch Sicherheitsfäden aus Material mit großer Koerzitivfeldstärke zu erkennen.

Aus WO 2010/006801 A1 ist eine Messvorrichtung zum Messen magnetischer Eigenschaften der Umgebung der Messvorrichtung mit einer Sensorzeile aus mindestens zwei in einer sich in eine Zeilenrichtung erstreckenden Zeile angeordneten magnetoresistiven Sensorelementen und einer Stützfeldvorrichtung bekannt, die ein magnetisches Stützfeld erzeugt, das eine in Zeilenrichtung weisende Magnetfeldkomponente aufweist, deren Feldstärke in Zeilenrichtung variiert, wobei dieser Feldstärkenverlauf in Zeilenrichtung an zumindest zwei in Zeilenrichtung nacheinander angeordneten Sensorrändern der die Sensorzeile bildenden Sensorelemente keinen Nulldurchgang und/oder kein Maximum oder Minimum aufweist. Bei der dort beschriebenen Messvorrichtung kann in einer bevorzugten Ausführungsform ein Vormagnetisierungsmagnet vorgesehen sein, der vor der Sensorzeile angeordnet ist. Mit diesem Vormagnetisierungsmagnet kann eine Magnetisierung eines Messobjekts mit hartmagnetischem Muster erfolgen, über den das Messobjekt zunächst geführt wird. Wird das Messobjekt anschließend über eine Sensorzeile geführt, so kann diese Sensorzeile das hartmagnetische Muster erkennen.

Bei der aus WO 2010/006801 A1 bekannten Messvorrichtung können in einer bevorzugten Ausführungsform zwei in Leserichtung der zu messenden Objekte nacheinander angeordnete Sensorzeilen vorgesehen sein, die zur Ermittlung unterschiedlicher Merkmale eingesetzt werden. Dort geht man von dem Gedanken aus, dass zur Erkennung der magnetischen Muster eine Vormagnetisierung des Geldscheins notwendig ist, die ausschließlich das hartmagnetische Muster erkennende Sensorzeile jedoch während der Messung kein Vormagnetisierungsfeld aufweisen darf, während zur Erkennung der weichmagnetischen Muster ein starkes Vormagnetisierungsfeld für die Sensorzeile am Ort der Messung notwendig ist. Bei der dort beschriebenen Ausführungsform können hartmagnetische und weichmagnetische Muster dadurch erkannt werden, dass das Vormagnetisierungsfeld im Bereich einer ersten Sensorzeile wirkt und die magnetischen Merkmale nahezu vollständig aufmagnetisiert und die Erkennung der weich- und hartmagnetischen Muster ermöglicht und zugleich der Vormagnetisierung der hartmagnetischen Strukturen dient. Wird der Geldschein anschließend über eine zweite Sensorzeile geführt, in deren Bereich das Vormagnetisierungsfeld nicht mehr wirkt, so kann diese zweite Sensorzeile separat das reln hartmagnetische Muster erkennen.

Aus DE 10 2008 061 507 A1 ist eine Messvorrichtung zum Messen magnetischer Eigenschaften der Umgebung der Vorrichtung bekannt. Diese weist eine erste Sensorzelle auf, die mehrere magnetosensitive Elemente mit einer ersten Hauptempfindlichkeitsrichtung aufweist. Ferner weist die bekannte Messvorrichtung eine zweite Sensorzeile auf, die mehrere magnetosensitive Elemente mit einer zweiten Hauptempfindlichkeitsrichtung aufweist. Die zweite Hauptempfindlichkeitsrichtung ist von der ersten Hauptempfindlichkeitsrichtung verschieden. Die Messvorrichtung weist neben einem Transportsystem zum Transportieren des Wertdokuments in einer Transportrichtung t entlang eines Transportwegs s einen ersten Vormagnetisierungsmagneten A zur Magnetisierung des Wertdokuments In eine erste Magnetisierungsrichtung und einen zweiten Vormagnetisierungsmagneten B zur Magnetisierung des Wertdokuments in eine zweite Magnetisierungsrichtung auf, wobei der zweite Vormagnetisierungsmagnet entlang des Transportwegs s nach dem ersten Vormagnetisierungsmagnet angeordnet ist. Ferner offenbart die DE 10 2008 061 507 A1 einen weiteren Magnetisierungsabschnitt C der zur Magnetisierung des Wertdokuments in eine weitere Magnetisierungsrichtung ausgebildet ist, wobei der weitere Magnetisierungsabschnitt C dazu ausgebildet ist, das Wertdokument während der Detektion des Wertdokuments durch die erste, durch die zweite oder durch eine - des Weiteren vorgesehenen - dritte Sensorzeile zu magnetisieren. In DE 10 2008 061 507 A1 wird In [0009] ferner eine bevorzugte Ausführungsform beschrieben, bei der die magnetoresistiven Elemente der ersten und zweiten Sensorzeile durch ein Vorspannungsmagnetfeld magnetisch vorgespannt werden, um einen geeigneten Arbeitspunkt auf deren Widerstandskennlinie einzustellen. Es wird empfohlen, zumindest eine Richtungskomponente des Vorspannungsmagnetfelds parallel oder antiparallel zur Hauptempfindlichkeitsrichtung des jeweils magnetisch vorzuspannenden magnetoresistiven Elements auszurichten. Eine gegenseitige Beeinflussung der Vormagnetisierungsmagneten und der Stützfeldvorrichtung (Vorspannungsmagnetfeld) ist in DE 10 2008 061 507 A1 nicht diskutiert.

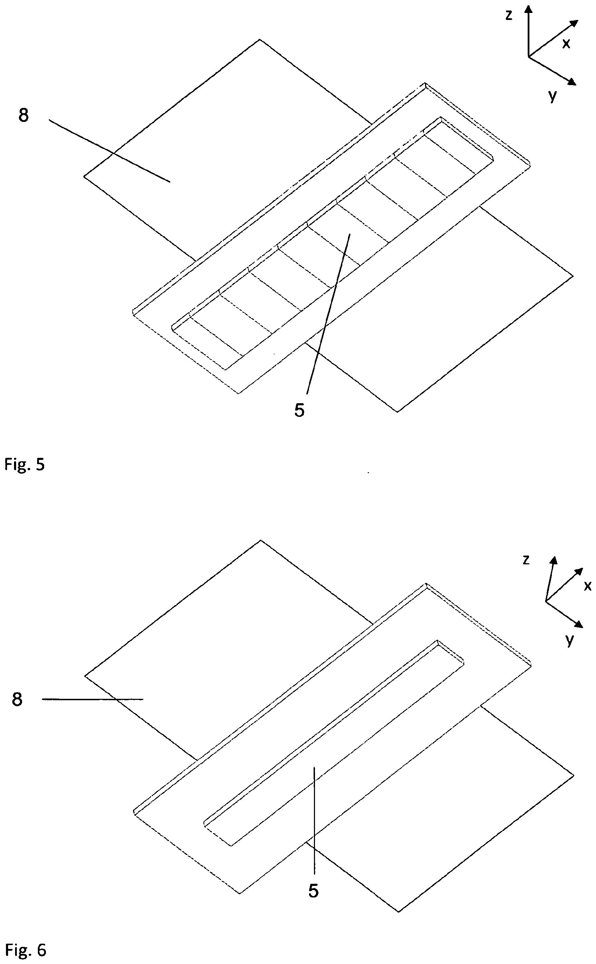

Aus DE 196 25 224 A1 ist eine Messvorrichtung bekannt, bei der zwei Polschuhe, zwei Detektoren, beispielsweise Spule, Hallsonden oder magnetisch sensitive Widerstände durchgreifen. Ferner ist den Detektoren in Bewegungsrichtung des zu untersuchenden Objekts vorgelagert ein Permanentmagnet vorgesehen. Um eine gute Wechselwirkung zwischen den Permanentmagneten und dem einen Polschuh zu erreichen, sind diese direkt miteinander verbunden, so dass das von den Permanentmagneten erzeugte Magnetfeld das Material des Polschuhs gut durchdringen kann. Die Polschuhe weisen weichmagnetisches Material auf. Die Stärke des Magnetfelds des Permanentmagneten wird so gewählt, dass das weichmagnetische Material des einen Polschuhs einen geeigneten magnetischen Arbeitspunkt aufweist. Im Zusammenhang mit den Figuren 5a, 5b beschreibt die DE 196 25 224 A1 hartmagnetische Partikel in dem zu untersuchenden Blattgut. Die hartmagnetischen Partikel sollen mit ihrem Südpol in Richtung der Polschuhe magnetisiert werden. Die Vormagnetisierung der hartmagnetischen Partikel kann beispielsweise vor der Messung durch einen in den Figuren 5a, 5b nicht dargestellten, starken Permanentmagneten oder den Permanentmagneten 25 durchgeführt werden. Eine Stützfeldvorrichtung wird in DE 196 25 224 A1 nicht beschrieben.

In DE 10 2005008 967 A1 wird ein Verfahren zum Massen magnetischer Eigenschaften eines Dokuments beschrieben, bei dem ein elektromagnetisches Wechselfeld erzeugt und das zu untersuchende Dokument in das elektromagnetische Wechselfeld eingebracht wird. Erfasst werden die Änderungen des elektromagnetischen Wechselfelds, während sich das Dokument in dem elektrischen Wechselfeld befindet.

Vor diesem Hintergrund lag der Erfindung die Aufgabe zugrunde, eine Messvorrichtung zum Messen magnetischer Eigenschaften der Umgebung der Messvorrichtung vorzuschlagen, die zumindest einen Nachteil der aus dem Stand der Technik bekannten Messvorrichtungen, bzw. Messverfahren nicht aufweist.

Diese Aufgabe wird durch die Gegenstände des Hauptanspruchs 1 gelöst. Vorteilhafte Ausführungsformen sind in den Unteransprüchen und der hiernach folgenden Beschreibung angegeben.

Die Erfindung geht von dem Grundgedanken aus, ein oder mehrere die Sensorzeile bildende magnetoresistive Sensorelemente einzusetzen, die im wesentlichen nur in einer als Messrichtung bezeichneten Richtung eines orthogonalen Koordinatensystems oder in einer als Sensormessebene bezeichneten, durch zwei senkrechte Messrichtungen eines orthogonalen Koordinatensystems aufgespannte Ebenen die magnetischen Eigenschaften seiner Umgebung messen können. Als Chip ausgeführte Sensorelemente, die auf einem magnetoresistiven Effekt beruhen, können so ausgeführt werden, dass sie die magnetischen Feldkomponenten in einer Messrichtung in der Chipebene detektiert. Derart als Chip ausgeführte Sensorelemente, die auf einem magnetoresistiven Effekt beruhen, können also nur bzw. im Wesentlichen feststellen, ob sich die Feldstärke einer einzigen in der Chipebene liegenden Feldkomponente des auf das Sensorelement einwirkenden Magnetfelds ändert. Dies kann beispielsweise durch ein sog. Barberpole Design erreicht werden, wie es beispielsweise in Dibbern, U. (2008) Magnetoresistive Sensors, in Sensors Set: A Comprehensive Survey (eds W. Göpel, J. Hesse and J. N. Zemel), Wiley-VCH Verlag GmbH, Weinheim, Germany beschrieben ist. Werden mehrere dieser Sensorelemente in einer Zeilenrichtung angeordnet, so können die Sensorelemente so ausgeführt werden, dass die Messrichtung senkrecht zur Zeilenrichtung ausgerichtet ist. Magnetoresistive Sensoren, die in planaren Dünnschichttechnologie gefertigt sind, sind nahezu unempfindlich auf die Feldkomponente senkrecht zur Chipebene, insbesondere auf Änderungen der Feldstärke der Feldkomponente senkrecht zur Chipebene des auf dem Chip einwirkenden Magnetfelds.

Bei derartigen Sensorelementen schlägt die Erfindung vor, dass
- bei einer nur aus einem Vormagnetisierungsmagneten bestehenden Vormagnetisierungsvorrichtung die das von ihm erzeugte magnetische Feld beeinflussenden Eigenschaften des Vormagnetisierungsmagneten und seine Anordnung relativ zur Sensorzeile sowie das von der Stützfeldvorrichtung erzeugte Stützfeld derart gewählt sind, dass ein Überlagerungsmagnetfeld aus der Überlagerung des von der Vormagnetisierungsvorrichtung erzeugten Magnetfelds und des Stützfelds entsteht, dessen Stärke der in Zeilenrichtung weisenden Feldkomponente zumindest an einem Ort auf der Sensorzeile größer ist als die Stärke der senkrecht zur Zeilenrichtung und nicht in Richtung der Höhe des Sensorelements weisenden Feldkomponente, oder
- bei einer aus mehreren Vormagnetisierungsmagneten bestehenden Vormagnetisierungsvorrichtung die das von ihnen erzeugte magnetische Feld beeinflussenden Eigenschaften der Vormagnetisierungsmagneten und die Anordnung der Vormagnetisierungsmagneten relativ zur Sensorzeile sowie das von der Stützfeldvorrichtung erzeugte Stützfeld derart gewählt sind, dass ein Überlagerungsmagnetfeld aus der Überlagerung des von der Vormagnetisierungsvorrichtung erzeugten Magnetfelds und des Stützfelds entsteht, dessen Stärke der in Zeilenrichtung weisenden Feldkomponente zumindest an einem Ort auf der Sensorzeile größer ist als die Stärke der senkrecht zur Zeilenrichtung und nicht in Richtung der Höhe des Sensorelements weisenden Feldkomponente.

Das Überlagerungsmagnetfeld wird als das auf die Sensorzeile wirkende Feld verstanden, wenn noch keine zu messenden, die magnetischen Eigenschaften der Umgebung der Sensorzeile bewirkenden Maßnahmen, wie beispielsweise das Vorbeiführen eines Geldscheins an der Sensorzeile vorbei, erfolgt sind. Das Überlagerungsmagnetfeld ist demnach das dauerhaft auf die Sensorzeile wirkende, aus der Überlagerung von dem von der Vormagnetisierungsvorrichtung erzeugten Vormagnetisierungsmagnetfeld und dem von der Stützfeldvorrichtung erzeugten Stützfeld entstehende Magnetfeld. Das Überlagerungsmagnetfeld ist in einer bevorzugten Ausführungsform zeitlich invariant.

Die erfindungsgemäß vorgeschlagene Wahl des Überlagerungsmagnetfelds bewirkt, dass das Vormagnetisierungsmagnetfeld den Einfluss des Stützfelds auf die Sensorzeile nicht nachteilig beeinflusst.

Die erfindungsgemäße Messvorrichtung weist eine Vormagnetisierungsvorrichtung auf, bei der zumindest ein Vormagnetisierungsmagnet in einer zur Zeilenrichtung senkrechten Richtung von der Sensorzeile beabstandet angeordnet ist und sich in einer Richtung parallel zur Zeilenrichtung erstreckt. Darunter wird verstanden, dass die Linie, die den Nordpol und den Südpol des Vormagnetisierungsmagneten verbindet, senkrecht zur Zeilenrichtung ausgerichtet ist, der Vormagnetisierungsmagnet erzeugt ein magnetisches Feld, das im Wesentlichen in Richtung der Höhe des Sensorelements weist. Damit ist die z-Richtung gemeint.

Erfindungsgemäß wird beansprucht, dass ein Überlagerungsmagnetfeld erzeugt wird, dessen Stärke der in Zeilenrichtung weisenden Feldkomponente zumindest an einem Ort auf der Sensorzeile größer ist als die Stärke der senkrecht zur Zeilenrichtung und nicht in Richtung der Höhe des Sensorelements weisenden Feldkomponente. Dabei wird unter dem Begriff "Stärke" insbesondere der Betrag der Feldkomponente verstanden, unabhängig davon, ob die Feldkomponente an diesem Ort in die positive Richtung der Feldkomponente oder in die negative Richtung der Feldkomponente weist.

Es kann sowohl im Falle eines Vormagnetisierungsmagneten als auch im Falle mehrerer Vormagnetisierungsmagneten insbesondere vorgesehen sein, dass die Stärke der Feldkomponente des aus der Überlagerung des von der Überlagerungsmagnetfelds (aus Überlagerung des von Vormagnetisierungsvorrichtung erzeugten Magnetfelds und des Stützfelds entstehend) in Zeilenrichtung zumindest an einem Ort auf der Sensorzeile kleiner ist als die Stärke der in Richtung der Höhe des Sensorelements weisenden Feldkomponente. Es kann sich somit ergeben, dass die Vormagnetisierungsvorrichtung die das von ihm erzeugte magnetische Feld beeinflussenden Eigenschaften des Vormagnetisierungsmagneten bzw. der Vormagnetisierungsmagneten und seine bzw. ihre Anordnung relativ zur Sensorzeile sowie das von der Stützfeldvorrichtung erzeugte Stützfeld derart gewählt sind, dass ein Überlagerungsmagnetfeld aus der Überlagerung des von der Vormagnetisierungsvorrichtung erzeugten Magnetfelds und des Stützfelds entsteht, dessen Stärke der in Zeilenrichtung weisenden Feldkomponente zumindest an einem Ort auf der Sensorzeile größer ist als die Stärke der senkrecht zur Zeilenrichtung wirkenden Feldkomponente, die nicht in Richtung der Höhe des Sensorelements weist, und die Stärke der in Zeilenrichtung weisenden Feldkomponente zumindest an einem Ort auf der Sensorzeile kleiner ist als die Stärke der in Richtung der Höhe des Sensorelements weisenden Feldkomponente. Insbesondere kann es vorgesehen sein, dass die Vormagnetisierungsvorrichtung und die Stützfeldvorrichtung räumlich voneinander getrennt angeordnet sind.

Es kann ermöglicht werden, die Feldkomponenten funktional zu "trennen". In Zeilenrichtung kann das Stützfeld für die Sensorelemente ausgerichtet sein. In Bewegungsrichtung des zu messenden Objekts (beispielsweise Geldschein oder Bogen), d.h. senkrecht zur Zeilenrichtung, aber nicht in Richtung der Erstreckung der Höhe der Sensorelemente, kann das Messfeld ausgerichtet sein. In Höhe der Sensorelemente kann die Vormagnetisierung ausgerichtet sein. Bevorzugt ist dabei die Feldkomponente in Zeilenrichtung klein, wobei die Feldkomponente in Bewegungsrichtung ohne Objekt möglichst Null sein kann und bei Vorhandensein eines Objekts vom Objekt abhängig ist, und insbesondere bevorzugt die Feldkomponente in Richtung der Höhe des Sensorelements sehr groß gewählt ist.

In einer bevorzugten Ausführungsform ist das, bzw. sind die die Sensorzeile bildenden Sensorelemente derart angeordnet und ausgebildet, dass sie im Wesentlichen nur in Zeilenrichtung die magnetischen Eigenschaften der Umgebung messen können, bzw. bei Sensorelementen, die im Wesentlichen nur in einer als Sensormessebene bezeichneten, durch zwei senkrechte Messrichtungen eines orthogonalen Koordinatensystems aufgespannten Ebene die magnetischen Eigenschaften seiner Umgebung messen können, die Zeilenrichtung eine dieser Messrichtungen ist.

In einer alternativen, ebenfalls bevorzugten Ausführungsform ist das bzw. sind die die Sensorzeile bildenden Sensorelemente derart angeordnet und ausgebildet, dass sie im Wesentlichen nur in eine Richtung senkrecht zur Zeilenrichtung die magnetischen Eigenschaften der Umgebung messen können. Wie vorstehend ausgeführt, ist es möglich, mehrere als Chip ausgeführte Sensorelemente, die auf einem magnetoresistiven Effekt beruhen, in einer Zeilenrichtung anzuordnen, sodass die Sensorelemente so ausgeführt werden, dass die empfindliche Messrichtung senkrecht zur Zeilenrichtung (und dabei nicht in Richtung der Höhe des Sensorelements) ausgerichtet ist.

In einer bevorzugten Ausführungsform ist auf mindestens 50% der Orte, insbesondere bevorzugt an mindestens 60% und insbesondere bevorzugt an mindestens 70% der Orte der Sensorzeile die Stärke der in Zeilenrichtung weisenden Feldkomponente des Überlagerungsmagnetfelds größer als die Stärke der senkrecht zur Zeilenrichtung und nicht in Richtung der Höhe des Sensorelements weisenden Feldkomponente des Überlagerungsmagnetfelds.

In einer bevorzugten Ausführungsform ist an den genannten Orten die Stärke der in Zeilenrichtung weisenden Feldkomponente des Überlagerungsmagnetfelds um das 10fache, insbesondere bevorzugt um das 100fache kleiner als die Stärke der senkrecht zur Zeilenrichtung und in Richtung der Höhe des Sensorelements weisende Feldkomponente des Überlagerungsmagnetfelds.

Bei einer derartigen Auslegung der Vormagnetisierungsvorrichtung kann der Vorteil erreicht werden, dass das von der Stützfeldvorrichtung erzeugte Stützfeld in der Messrichtung, bzw. in der Sensormessebene, auf die das Messen der magnetischen Eigenschaften durch das Sensorelement beschränkt ist, ungestört von einer Überlagerung eines weiteren magnetischen Feldes durch die Vormagnetisierungsvorrichtung erzeugt werden kann. Dieser Aspekt der Erfindung birgt insbesondere den Vorteil, dass durch den Vormagnetisierungsmagnet die gewünschte Magnetisierung des Objekts, das die magnetischen Eigenschaften der Umgebung der Messvorrichtung beeinflussen soll, um diese durch die Messvorrichtung messen zu lassen, erfolgen kann, ohne die Messeigenschaften des Sensorelements signifikant zu beeinflussen.

Die erfindungsgemäße Messvorrichtung bietet den Vorteil, dass die zur Vormagnetisierung der hartmagnetischen Materialien notwendigen Maßnahmen und die für das Erkennen weichmagnetischer Materialien notwendigen Maßnahmen von der für den Sensorbetrieb notwendigen Stützfeldverteilung getrennt werden können. Der Vormagnetisierungsmagnet kann als erste magnetische Funktionsgruppe zumindest die hartmagnetischen Materialien und - soweit gewünscht - die weichmagnetischen Materialien während deren Messung magnetisieren. Die Stützfeldvorrichtung als zweite magnetische Funktionsgruppe kann eine Verteilung der in Zeilenrichtung weisenden Stützfeld-Magnetfeldkomponente liefern, die einen möglichst empfindlichen und lückenlosen Nachweis magnetischer Sicherheitsmerkmale ermöglicht.

Die erfindungsgemäße Messvorrichtung bietet den weiteren Vorteil, dass die Stützfeldvorrichtung so ausgelegt, insbesondere bevorzugt mit einem oder mehreren so kleinen Stützfeldmagneten ausgeführt werden kann, dass die Stützfeldvorrichtung lediglich die Funktion erfüllt, eine Verteilung der in Zeilenrichtung weisenden Stützfeld-Magnetfeldkomponente zu liefern, die einen möglichst empfindlichen und lückenlosen Nachweis magnetischer Sicherheitsmerkmale ermöglicht. Es wurden Versuche unternommen, die Stützfeldvorrichtung derart auszulegen, dass das von ihr erzeugte Stützfeld auch in der Lage war, weichmagnetische Materialien während der Messung zu magnetisieren. Hierfür ist es notwendig, eine Stützfeldvorrichtung mit mindestens einem Stützfeldmagneten zu verwenden, bei dem das von ihm erzeugte Magnetfeld nicht nur im Bereich der Sensorelemente, sondern auch in dem Bereich eine Wirkung entfaltet, in dem sich das zu untersuchende Messobjekt befindet, bzw. durch den das zu untersuchende Messobjekt bewegt wird. Insbesondere musste ein Stützfeldmagnet eingesetzt werden, dessen Magnetfeld in dem Bereich, in dem sich das zu untersuchende Messobjekt befindet, bzw. durch den das zu untersuchende Messobjekt bewegt wird, eine Wirkung entfaltet, die ausreicht, um weichmagnetische Materialien während der Messung zu magnetisieren. Es hat sich gezeigt, dass hierfür relativ große Stützfeldmagneten eingesetzt werden müssen. Da es die erfindungsgemäße Messvorrichtung nun erlaubt, die Stützfeldvorrichtung so auszulegen, dass sie allein die Funktion erfüllt, eine Verteilung der in Zeilenrichtung weisenden Stützfeld-Magnetfeldkomponente zu liefern, die einen möglichst empfindlichen und lückenlosen Nachweis magnetischer Sicherheitsmerkmale ermöglicht, kann die Stützfeldvorrichtung besonders kompakt ausgebildet werden.

In einer besonders bevorzugten Ausführungsform werden die zunächst unmagnetisierten Stützfeldmagnete in einem gemeinsamen Arbeitsgang mit den Sensoren auf einer Trägerplatte aufgelötet. Bevorzugt werden die Stützfeldmagnete nach dem Auflöten magnetisiert.

In einer bevorzugten Ausführungsform bei einer aus einem Vormagnetisierungsmagneten bestehenden Vormagnetisierungsvorrichtung sind die das von ihm erzeugte magnetische Feld beeinflussenden Eigenschaften des Vormagnetisierungsmagneten und seine Anordnung relativ zur Sensorzeile derart gewählt, dass an keiner Stelle eines Sensorelements der Sensorzeile die Feldstärke des durch den Vormagnetisierungsmagneten erzeugten magnetischen Felds in keiner der drei Richtungen, zumindest aber insbesondere in keiner von zwei Richtungen eines orthogonalen Koordinatensystems stärker ist als die Feldstärke des durch die Stützfeldvorrichtung erzeugten Magnetfelds in der jeweils entsprechenden Richtung des orthogonalen Koordinatensystems, sofern die Zeilenrichtung betrachtet wird. In einer bevorzugten Ausführungsform bei einer aus mehreren Vormagnetisierungsmagneten bestehenden Vormagnetisierungsvorrichtung sind die das von ihnen erzeugte magnetische Feld beeinflussenden Eigenschaften der Vormagnetisierungsmagneten und die Anordnung der Vormagnetisierungsmagneten relativ zur Sensorzeile derart gewählt sind, dass an keiner Stelle eines Sensorelements der Sensorzeile die Feldstärke des durch die Überlagerung der von den Vormagnetisierungsmagneten jeweils einzeln erzeugten magnetischen Felder erzeugten magnetischen Feldes in keiner der drei Richtungen, zumindest aber insbesondere in keiner von zwei Richtungen eines orthogonalen Koordinatensystems stärker ist als die Feldstärke des durch die Stützfeldvorrichtung erzeugten Magnetfeldes in der Messrichtung, sofern die Zeilenrichtung betrachtet wird.

Bei der erfindungsgemäßen Messvorrichtung ist eine Sensorzeile mit mindestens einem sich in eine Zeilenrichtung erstreckenden magnetoresistiven Sensorelement vorgesehen, das magnetische Eigenschaften in seiner Umgebung messen kann. Das Sensorelement kann zum Messen der magnetischen Eigenschaften in seiner Umgebung insbesondere so ausgebildet sein, dass es den "anisotropen" magnetoresistiven Effekt (AMR-Effekt) oder den "gigantischen" magnetoresistiven Effekt (GMR-Effekt) aufweist. Das Sensorelement kann allerdings auch andere Effekte aufweisen, wie beispielsweise den Giant-Magneto-Impedance- (GMI), den Tunnel-Magneto-Resistance-Effekt (TMR) oder den Hall-Effekt.

Ein Sensorelement weist insbesondere bevorzugt vier oder mehrere zu einer Wheatstone-Brücke zusammen geschaltete einzelne Brückenwiderstände oder zwei oder mehrere zu einer halben Wheatstone'schen Brücke zusammen geschaltete einzelne Brückenwiderstände auf.

Das Sensorelement weist eine Breite und eine Länge sowie eine Höhe auf, wobei die Höhe geringer ist als die Breite und die Höhe geringer ist als die Länge und die Zeilenrichtung in Richtung der Breite oder in Richtung der Länge des Sensorelements weist.

In einer bevorzugten Ausführungsform weist das Sensorelement Widerstände auf, wobei der von den Widerständen gesamthaft eingenommene Raum eine Breite und eine Länge sowie eine Höhe aufweist, wobei die Höhe geringer ist als die Breite und die Höhe geringer ist als die Länge und die Zeilenrichtung in Richtung der Breite oder in Richtung der Länge des Sensorelements weist. Es ist denkbar, dass bei Sensorelementen mit Widerständen weitere Baugruppen als Teil des Sensorelements vorgesehen werden, wie beispielsweise elektrische Leitungen zum Anlegen einer Spannung an die Widerstände oder zum Messen einer Spannung. Diese Leitungen können in Richtung der Höhe abgeführt werden und dazu führen, dass das Sensorelement eine verhältnismäßig große Höhe erreicht, die beispielsweise auch der der Breite entsprechen kann. Bei solchen Bauformen ist es bevorzugt, dass zumindest der Raum, der von den Widerständen eingenommen wird die vorbeschriebene Auslegungsregel erfüllt.

Es kann auch vorgesehen sein, dass die Sensorelemente in Gruppen, d.h. zu mehreren in einer linienförmigen Anordnung bzw. linienförmigen Gruppe zum Ausbilden der Sensorzeile angeordnet sein können. Eine Anordnung bzw. Gruppe von Sensorelementen kann in einem Gehäuse angeordnet sein. Benachbarte Sensorelemente in einer Gruppe bzw. in einem Gehäuse weisen den gleichen Abstand auf. Die Gehäuse zur Ausbildung der Zeile können insbesondere so zueinander beabstandet sein, dass die benachbarten Sensorelemente von zueinander benachbarten Gehäusen bzw. Gruppen zum Aufbau einer Zeile den gleichen Abstand aufweisen wie der Abstand der Sensorelemente in einem Gehäuse zueinander.

Die Vorteile der Erfindung können bereits mit einem sich in eine Zeilenrichtung erstreckenden magnetoresistiven Sensorelement erreicht werden. Dabei wird bei einem sich in eine Zeilenrichtung erstreckenden, vier oder mehrere zu einer Wheatstone'schen Brücke zusammengeschalteten einzelne Brückenwiderstände aufweisenden Sensorelement das Erstrecken in eine Zeilenrichtung derart verstanden, dass zumindest zwei dieser Einzelwiderstände in Zeilenrichtung nebeneinander angeordnet sind. Besonders bevorzugt weist die Sensorzeile jedoch mindestens zwei magnetoresistive Sensorelemente auf, die in Zeilenrichtung hintereinander angeordnet sind. Die Länge der Sensorzeile und damit die Zahl der verwendeten magnetoresistiven Sensorelemente hängt von der durchzuführenden Messung ab. Zur Messung von Euro-Banknoten kann eine Sensorzeile beispielsweise mehr als 10, insbesondere bevorzugt mehr als 20, beispielsweise mehr als 31 und bevorzugt 90 Sensorelemente aufweisen, insbesondere wenn die Vorrichtung dafür eingesetzt wird, Euro-Banknoten zu messen, die mit ihrer kurzen Seite in einer Messrichtung relativ zur Messvorrichtung bewegt werden.

Zur Bildung der Sensorzeile sind - soweit vorhanden - die Sensorelemente in einer Zeile angeordnet. Insbesondere bevorzugt liegen die Sensorelemente auf einer Linie. Es ist aber auch denkbar, dass die Sensorelemente einer einzelnen Zeile bezogen auf eine in Zeilenrichtung weisende Achse unterschiedlich angeordnet sind, sodass die Längsmittelachsen der Einzelsensoren nicht mehr alle auf einer Linie liegen. Insbesondere bevorzugt sind derart angeordnete Sensorelemente jedoch so angeordnet, dass sie sich in Richtung der Zeilenrichtung gesehen teilweise überlappen.

In einer bevorzugten Ausführungsform sind mehrere Sensorelemente zu einer Baugruppe zusammengefasst, beispielsweise auf einer gemeinsamen Trägerstruktur angeordnet. Eine solche Baugruppe wird nachfolgend als Sensor bezeichnet. Ein Sensor kann beispielsweise zwei, drei, vier oder mehr Sensorelemente aufweisen. Es ist aber auch möglich, dass ein Sensor durch ein einziges Sensorelement gebildet wird.

Die erfindungsgemäße Messvorrichtung ist zum Messen magnetischer Eigenschaften der Umgebung der Messvorrichtung geeignet. Unter magnetischen Eigenschaften der Umgebung der Messvorrichtung werden insbesondere die Magnetfeldstärke eines magnetischen Feldes in der Umgebung der Messvorrichtung, die Feldrichtung eines magnetischen Feldes in der Umgebung der Messvorrichtung oder aber auch beispielsweise die Änderung der Feldstärke, bzw. Feldrichtung eines magnetischen Feldes in der Umgebung der Messvorrichtung verstanden. Beispielsweise wird als magnetische Eigenschaft der Umgebung die Änderung der Feldstärke und der Feldrichtung des die Messvorrichtung umgebenden magnetischen Feldes verstanden, wenn sich dieses Feld durch Überlagerung eines Feldes ändert, das von einem magnetischen Muster einer Banknote erzeugt wird. In einer bevorzugten Ausführungsform wird die Sensorzeile so ausgelegt, dass sie nur räumliche und/oder zeitliche Änderungen der magnetischen Eigenschaften der Umgebung der Messvorrichtung detektiert.

Das Sensorelement ist derart ausgebildet, dass es magnetische Eigenschaften der Umgebung der Messvorrichtung, wozu definitionsgemäß auch die Änderung einer Feldstärke gehört, nur in einer als Messrichtung bezeichneten Richtung eines orthogonalen Koordinatensystems messen kann, bzw. in einer alternativen Ausführungsform nur in zwei Richtungen eines orthogonalen Koordinatensystems messen kann, die in einer als Sensormessebene bezeichneten Ebene liegen.

In einer bevorzugten Ausführungsform ist die erfindungsgemäße Messvorrichtung zum Messen magnetischer Strukturen eines Scheins oder eines Bogens, insbesondere eines Geldscheins oder Schecks, ausgebildet und weist geeignete Mittel auf, um den Schein oder den Bogen zumindest in einem der Sensorzeile benachbarten Bereich in einer Messebene an der Sensorzeile vorbei zu bewegen. Dabei wird die Richtung, in die der Schein, bzw. der Bogen bewegt wird, als Leserichtung bezeichnet. Insbesondere bevorzugt ist das Sensorelement derart ausgebildet, dass die Messrichtung der Leserichtung entspricht, das Sensorelement also nur bzw. im Wesentlichen magnetische Eigenschaften seiner Umgebung in Leserichtung messen kann.

Die erfindungsgemäß eingesetzte Stützfeldvorrichtung sowie der Vormagnetisierungsmagnet können aus einem oder mehreren Bauteilen, beispielsweise Permanentmagneten bestehen. Insbesondere bevorzugt wird die erfindungsgemäße Stützfeldvorrichtung durch einen Einzelmagneten mit lokal variierender Magnetisierungsverteilung gebildet, insbesondere bevorzugt durch einen Polstreifen. In einer bevorzugten Ausführungsform weisen die Stützfeldvorrichtung und/oder der Vormagnetisierungsmagnet Permanentmagneten auf. Der Vormagnetisierungsmagnet und/oder die Stützfeldvorrichtung können jedoch auch elektrische Spulen aufweisen, die das gewünschte Magnetfeld erzeugen.

In einer bevorzugten Ausführungsform sind die Sensorelemente in Zeilenrichtung äquidistant angeordnet. In einer besonders bevorzugten Ausführungsform beträgt der Abstand eines ersten Sensorelements zu einem benachbarten Sensorelement. bezogen auf den Abstand zwischen den Mittelpunkten der beiden Sensorelemente, zwischen 1 und 10 mm, vorzugsweise zwischen 2 und 5 mm und insbesondere bevorzugt 3,5 mm. In einer besonders bevorzugten Ausführungsform weist ein Chip zwei in Zeilenrichtung nach einander angeordnete Sensorelemente auf und weist - ohne Gehäuse - eine Länge von 1,5 bis 9 mm, vorzugsweise von 2 bis 3 mm und insbesondere bevorzugt von 2,5 mm in Zeilenrichtung auf. In einer bevorzugten Ausführungsform beträgt der Abstand von einem Rand eines Chips zu dem Rand des benachbarten Chips weniger als 1,5 mm und insbesondere bevorzugt weniger als 1,1 mm.

In einer alternativen Ausführungsform sind die Sensorelemente derart angeordnet, dass der Abstand zwischen zwei Rändern zweier benachbarter Sensorelemente, die auf einem Chip angeordnet sind, kleiner ist, als der Abstand zwischen zwei Rändern benachbarter Sensorelemente, die nicht auf einem Chip angeordnet sind. Der Abstand zwischen zwei Chips ist in der Regel durch die Technologie vorgegeben, mit der ein Chip auf einer Trägerplatte verbunden werden kann. Diese Technologien benötigen in der Regel mehr Raum als der Raum, der benötigt wird, um zwei magnetoresistive Sensorelemente auf einem Chip anzuordnen. Die Empfindlichkeit der Messvorrichtung kann deshalb dadurch gesteigert werden, dass sowohl die Anbringung der Sensorelemente auf dem Chip als auch die Anbringung der Chips auf dem Board so dicht wie nach der jeweils eingesetzten Technologie möglich erfolgt.

Die Herstellung der Sensorelemente auf den Chips erfolgt bevorzugt mit den Methoden der Planartechnik, Halbleitertechnik oder Mikrosystemtechnik.

In einer bevorzugten Ausführungsform werden in eine Leiterplatte Vertiefungen zur Aufnahme des Vormagnetisierungsmagneten eingebracht, insbesondere bevorzugt eingefräst. Dies erlaubt es, bei gleich bleibendem übrigem Bauraum größere Magneten zu verwenden und erlaubt damit die Erhöhung der Feldstärke am Ort des Wertdokuments bzw. der Sensorzeile.

Die Verbesserung der Messgenauigkeit wird bereits erreicht, wenn an mindestens zwei in Zeilenrichtung nacheinander angeordneten Sensorrändern der Feldstärkenverlauf in Zeilenrichtung keinen Nulldurchgang und/oder kein Maximum oder Minimum aufweist. Dabei müssen diese in Zeilenrichtung nacheinander angeordneten Sensorränder nicht einander unmittelbar folgen. Vorteile werden auch erreicht, wenn der Feldstärkenverlauf in Zeilenrichtung an einem beliebigen Rand eines beliebigen ersten Sensorelements der Sensorzeile und an einem beliebigen Rand eines beliebigen zweiten Sensorelements der Sensorzeile keinen Nulldurchgang und/oder kein Maximum oder Minimum aufweist, solange es sich um Ränder handelt, die über die gesamte Ausdehnung der Sensorzeile in Zeilenrichtung nacheinander angeordnet sind.

Es kann bei einer Ausführungsform der erfindungsgemäßen Messvorrichtung vorgesehen sein, dass der Feldstärkenverlauf in Zeilenrichtung an einem Sensorrand der die Sensorzeile bildenden Sensorelemente einen Nulldurchgang und/oder ein Maximum oder Minimum aufweist. Vorteile in Bezug auf die Messgenauigkeit können dann auch an anderen Sensorelementrändern erzielt werden. In einer besonders bevorzugten Ausführungsform der erfindungsgemäßen Messvorrichtung wird ein Stützfeld erzeugt, bei dem der Feldstärkenverlauf in Zeilenrichtung an allen in Zeilenrichtung nacheinander angeordneten Sensorrändern der die Sensorzeile bildenden Sensorelemente keinen Nulldurchgang und/oder kein Maximum oder Minimum aufweist. Beispielsweise wird das Stützfeld durch jeweils einen Magneten pro Sensorelement erzeugt. Dieser Magnet kann im einfachsten Fall während der Herstellung des Sensorelements unmittelbar auf dem Sensor aufgebracht werden.

Das Stützfeld kann zeitvariant sein, beispielsweise impulsartig aufgeprägt werden. In einer bevorzugten Ausführungsform ist das Stützfeld jedoch zeitinvariant und liegt stets in der gleichen Weise an. Dies vereinfacht insbesondere den Aufbau der Messvorrichtung, da zur Erzeugung des Stützfelds auf Permanentmagneten zurückgegriffen werden kann.

In einer bevorzugten Ausführungsform ist der Feldstärkenverlauf in Zeilenrichtung periodisch und hat in einer besonders bevorzugten Ausführungsform als Periode ein ganzzahliges Vielfaches oder einen ganzzahligen Bruchteil des bevorzugt gleichbleibenden Abstands zwischen den Sensorelementen der Sensorzeile (als Abstand wird der Abstand zwischen den Mittelpunkten zweier benachbarter Sensorelemente verstanden). In einer besonders bevorzugten Ausführungsform weist die Stützfeldvorrichtung am Anfang und am Ende der Sensorzeile Anordnungen von Magneten auf, die auch an den Enden der Zeile zu einem im wesentlichen periodischen Verlauf der Feldstärke in Zeilenrichtung über die Sensorzeile führen. Dies kann erreicht werden, indem die Magnetanordnung, bevorzugt mindesten 3 weitere, über das Ende der Sensorzeile hinausragende Pole besitzt. In einer bevorzugten Ausführungsform werden zur Verkürzung der Gesamtbaulänge die Randeffekte durch eine Modifikation der Geometrie oder Magnetisierung oder Anordnung der äußeren Magnete vermindert, beispielsweise in dem die Länge des äußeren Magneten am jeweiligen Ende der Sensorzeile um ca. 30% der Magnetperiode verlängert wird.

In einer bevorzugten Ausführungsform weist die Stützfeldvorrichtung eine Zeile nebeneinander, insbesondere in Zeilenrichtung der Sensorelemente nebeneinander angeordneter Magnete auf. Die Magnetisierung der Magneten dieser Zeile kann alternierend sein, so dass die Magnetisierung eines Magneten entgegengesetzt zu der Magnetisierung seiner benachbarten Magneten ist. Die in einer Zeile nebeneinander angeordneten Magneten können jedoch auch die gleiche Magnetisierung aufweisen. In diesem Fall sind die Magneten besonders bevorzugt in Zeilenrichtung beanstandet voneinander angeordnet. Die in einer Zeile nebeneinander angeordneten Magneten können jedoch auch wechselnde Magnetisierung auf weisen, die das sensorelementseitige Feld verstärken und das rückseitige Feld schwächen.

In einer bevorzugten Ausführungsform, insbesondere bei in Zeilenrichtung nebeneinander (hintereinander angeordneten Magneten, bei denen die Magnetisierung der Magneten von einem zum benachbarten Magneten alterniert, sind die Magneten unmittelbar aneinander angrenzend angeordnet. Dies führt zu einem homogenen Verlauf des Stützfelds. In einer bevorzugten Ausführungsform kann die Messvorrichtung Mittel zur Erzeugung eines zeitlich variierenden, inhomogenen Magnetfeldes beinhalten. Alternativ kann die Messvorrichtung Mittel zur Erzeugung eines zeitlich variierenden, homogenen Magnetfeldes beinhalten.

Die Stützfeldvorrichtung kann insbesondere aus plastikgebundenem Hartferrit oder Seltenerdmagneten, die gespritzt oder gepresst wurden oder aus gesinterten Seltenerdmagneten oder anderen Permanentmagnetwerkstoffen hergestellt werden. Die Stützfeldvorrichtung kann eine Anordnung permanentmagnetischer Magnete aufweisen, die im unmagnetischen Zustand auf einer Trägerplatte aufgebracht und erst danach gemeinsam magnetisiert werden.

In einer bevorzugten Ausführungsform ist eine Stützfeldvorrichtung mit einer Zeile nebeneinander angeordneten Magneten, bei denen die Magnetisierung alterniert, im Verhältnis zur Sensorzeile so angeordnet, dass der Übergang von einem Magneten zum benachbarten Magneten in der Mitte zumindest eines Sensorelements, bezogen auf seine Ausdehnung in Zeilenrichtung angeordnet ist. Dadurch wird auf einfache Weise erreicht, dass der Feldstärkenverlauf in Zeilenrichtung an nacheinander angeordneten Sensorrändern der die Sensorzeile bildenden Sensorelemente keinen Nulldurchgang und/oder kein Maximum oder Minimum aufweist.

Die erfindungsgemäße Messvorrichtung weist einen Vormagnetisierungsmagneten auf, der in einer zur Zeilenrichtung senkrechten Richtung von der Sensorzeile beabstandet angeordnet ist und sich in einer Richtung parallel zur Zeilenrichtung erstreckt. Dabei kann es zum Erreichen der erfindungsgemäßen Vorteile bereits ausreichen, einen einzigen Vormagnetisierungsmagneten vorzusehen. Besonders bevorzugt ist die Erstreckung des Vormagnetisierungsmagneten in die Richtung parallel zur Zeilenrichtung der Sensorzeile auf die Länge der Sensorzeile abgestimmt. Insbesondere bevorzugt ist der Vormagnetisierungsmagnet in eine Richtung parallel zur Zeilenrichtung etwas länger, als die Sensorzeile in Zeilenrichtung lang ist. Dies kann durch einen entsprechend ausgeformten einzigen Magneten erreicht werden. In einer bevorzugten Ausführungsform sind mehrere Vormagnetisierungsmagneten vorgesehen, die in einer Richtung parallel zur Zeilenrichtung der Sensorzeile benachbart zu einander angeordnet sind.

In einer besonders bevorzugten Ausführungsform ist die Messvorrichtung dazu ausgebildet, magnetische Strukturen eines Scheins oder eines Bogens, insbesondere eines Geldscheins zu erkennen, und weist geeignete Mittel auf, um den Schein oder Bogen zumindest in einem der Sensorzeile benachbarten Bereich in einer Messebene an der Sensorzeile vorbei zu bewegen. Die Messebene ist die Ebene, in der sich der Schein oder der Bogen befindet, wenn er untersucht wird. Demgegenüber wird als Sensormessebene die Ebene verstanden, in der ein entsprechend ausgeführtes magnetoresistives Sensorelement die Eigenschaften seiner Umgebung messen kann. Die Sensormessebene ist die Ebene, in der die für die Messungen wirksamen Elemente des Sensorelements liegen und die dort die Eigenschaften des auf sie einwirkenden Magnetfeldes messen. Die Messebene ist beabstandet zu der Sensormessebene. Das Bewegen des zu untersuchenden Messobjekts durch die Messebene bewirkt jedoch auch eine Veränderung des auf die Sensorelemente in der Sensormessebene einwirkenden Magnetfeldes. Das Beobachten der Änderung der Eigenschaften des in der Sensormessebene auf das Sensorelement wirkenden Magnetfeldes erlaubt somit Rückschlüsse auf Gegebenheiten, beispielsweise den Hindurchtritt von magnetischem bzw. magnetisierbarem Material durch die Messebene. Für das Bewegen des Scheins oder Bogens geeignete Mittel sind insbesondere Walzen, die einen Walzspalt zwischen sich bilden, in der der Schein oder der Bogen gehalten werden kann. Werden zwei Gruppen solcher Walzen verwendet und die zwischen den Walzen der jeweiligen Gruppe gebildeten Walzspalte entsprechend zueinander ausgerichtet, so kann ein Schein oder ein Bogen zwischen den beiden Walzengruppen in einer Ebene an der Sensorzeile vorbei bewegt werden. Ebenso kann der Schein oder Bogen auf einem Transportband, beispielsweise einem eine Gummioberfläche aufweisenden Transportband oder einem aus einem Fließ bestehenden Transportband liegend an der Sensorzeile vorbei bewegt werden.

In einer bevorzugten Ausführungsform weist die Messvorrichtung Mittel auf, um den Schein oder den Bogen zumindest in einem der Sensorzeile benachbarten Bereich in einer Messebene an der Sensorzeile vorbei zu bewegen. In dieser bevorzugten Ausführungsform sind die das von ihm erzeugte magnetische Feld beeinflussenden Eigenschaften des Vormagnetisierungsmagneten und seine Anordnung relativ zur Sensorzeile derart gewählt, dass die Feldstärke des durch den Vormagnetisierungsmagneten erzeugten magnetischen Feldes in allen Richtungen eines orthogonalen Koordinatensystems am Ort der Messebene größer ist, als an einer Stelle der Sensorzeile. Bei den Ausführungsformen, bei denen ein Sensorelement verwendet wird, das im Wesentlichen nur in einer als Sensormessebene bezeichneten Ebene die magnetischen Eigenschaften seiner Umgebung messen kann, kann in dieser bevorzugten Ausführungsform die Feldstärke des durch den Vormagnetisierungsmagneten erzeugten magnetischen Feldes in allen Richtungen eines orthogonalen Koordinatensystems am Ort der Messebene größer als an einem Ort der Sensormessebene sein.

In einer besonders bevorzugten Ausführungsform bildet der Vormagnetisierungsmagnet einen ersten Vormagnetisierungsmagneten, wobei ein zweiter Vormagnetisierungsmagnet vorgesehen ist, der in einer Richtung von der Sensorzeile beabstandet angeordnet ist, die zu der Richtung, in der der erste Vormagnetisierungsmagnet beabstandet zur Sensorzeile angeordnet ist, entgegengesetzt ist. Dies ermöglicht eine von der Leserichtung eines relativ zur Messvorrichtung zu bewegenden Scheins oder Bogens unabhängige Detektion. Zudem kann durch eine derartige Ausführungsform der Einfluss der Vormagnetisierung auf das Stützfeld verringert werden.

In einer bevorzugten Ausführungsform sind die Sensorzeile, die Vormagnetisierungsvorrichtung und die Stützfeldvorrichtung in einem Gehäuse integriert. Insbesondere bevorzugt werden die Sensorzeile, die Vormagnetisierungsvorrichtung und die Stützfeldvorrichtung auf einer Leiterplatte integriert. Vormagnetisierungsvorrichtung und/oder Stützfeldvorrichtung können aber auch Bestandteil des Gehäuses sein. In einer bevorzugten Ausführungsform weist das Gehäuse eine Vorrichtung zur Fixierung eines Schutzbleches auf, das Sensorzeile und/oder Vormagnetisierungsvorrichtung vor Abrieb schützt.

In einer bevorzugten Ausführungsform weist die Sensorzeile mindestens zwei Sensorelemente auf. Jedes dieser Sensorelemente weist zumindest eine Signalleitung auf, über die das Sensorelement ein Sensorsignal abgibt. In dieser bevorzugten Ausführungsform ist zumindest ein Multiplexer vorgesehen, dem die Signalleitungen der Sensorelemente zugeführt werden. Der Multiplexer bearbeitet die Sensorsignale der Signalleitungen so, dass ein einziges Signal an einer Ausgangsleitung des Multiplexers ausgegeben werden kann, dass auf Grundlage der Sensorsignale der Signalleitungen erzeugt wurde. In einer bevorzugten Ausführungsform sind mehrere Multiplexer vorgesehen, wobei einem ersten Multiplexer die Signalleitungen einer ersten Gruppe von Sensorelementen zugeführt wird und einem zweiten Multiplexer die Signalleitungen einer zweiten Gruppe von Sensorelementen zugeführt wird.

In einer bevorzugten Ausführungsform weist die Messvorrichtung eine Signalaufbereitungs- und/oder Signalauswertungseinrichtung auf. Diese Signalaufbereitungs- und/oder Signalauswertungseinrichtung kann in einer Mikrokontrollereinheit angeordnet sein. In einer bevorzugten Ausführungsform ist eine Mikrokontrollereinheit vorgesehen, die Algorithmen zur Unterdrückung von Störeinflüssen anwendet, Der Algorithmus kann insbesondere zur Identifikation des Messobjekts oder zur Entschlüsselung von Kodierungen ausgelegt sein.

In einer bevorzugten Ausführungsform weist die Messvorrichtung Signalaufbereitungs- und/oder Signalauswertungseinrichtungen für jeden Signalleitung und/oder für jede Ausgangsleistung auf. Jeder Signalleitung und/oder jede Ausgangsleitung einen mindestens einstufigen Verstärker aufweisen. Der Vorverstärker kann temperaturkompensiert sein. Der Verstärkungsfaktor des Vorverstärkers kann individuell eingestellt werden. Der Verstärker kann so ausgelegt sein, dass nur eine bestimmte Bandbreite verstärkt wird, um Rausch- und Störeinflüsse zu minimieren. Die Bandbreite richtet sich beispielsweise auch nach der Geschwindigkeit der transportierten Banknoten und der Größe der zu detektierenden Merkmale. Die Signale können direkt ausgegeben werden oder können in einem Analog-Digital-Wandler digitalisiert und in einem Mikrokontroller verarbeitet werden.

In einer bevorzugten Ausführungsform werden die verstärkten oder unverstärkten Sensorsignale der Signalleitungen durch den Multiplexer in zeitlicher Folge auf eine Ausgangssignalleitung zusammengefasst. Das Signal der Ausgangssignalleitung wird dann verstärkt oder unverstärkt zur Digitalisierung einem A/D-Wandler zugeführt und kann verstärkt oder unverstärkt in einer Mikrokontrollereinheit verarbeitet werden.

Das Messergebnis kann in verschiedenen Formen an die weiterverarbeitenden Einheiten weitergegeben werden: In den weiterverarbeitenden Einheiten kann eine Bewertung aller gemessenen Eigenschaften - hauptsächlich optische, aber auch mechanische und elektrische und die magnetischen Eigenschaften - vorgenommen werden.

Hierbei kann die Funktion der weiterverarbeitenden Einheit auch in der Messvorrichtung selbst ganz oder teilweise wahrgenommen werden. Die weiterverarbeitende Einheit kann beispielsweise auch als Teil der Mikrokontrollereinheit ausgebildet sein. Insofern kann die Mikrokontrollereinheit die Auswertung vornehmen.

In einer bevorzugten Ausführungsform und alternativ zu den Ausführungsformen, bei denen eine Mulitplexer eingesetzt wird, kann die Sensorzeile über jede Signalleitung ein analoges Signal ausgeben.

In einer bevorzugten Ausführungsform und unabhängig davon, ob ein Multiplexer oder kein Mulitplexer eingesetzt wird, kann die Messvorrichtung digitale Signale nach einem Protokoll ausgeben, beispielsweise nach dem Protokoll einer seriellen Schnittstelle oder nach dem Protokoll eines USB-Anschluss.

In einer bevorzugten Ausführungsform ist die Sensorzeile durch ein Gehäuse umschlossen. Insbesondere bevorzugt ist die Sensorzeile durch ein Gehäuse umschlossen, dessen Fläche, die Kontakt zum Messobjekt hat, einen möglichst kleinen Abstand zum Messobjekt zulässt und abriebsfest gestaltet ist. In einer bevorzugten Ausführungsform ist die Sensorzeile durch ein Gehäuse umschlossen ist, dessen Wände, außer der Wand, die Kontakt zum Messobjekt hat, eine magnetische Abschirmung darstellen. In einer bevorzugten Ausführungsform ist die Stützfeldvorrichtung im Sensorgehäuse integriert.

In einer bevorzugten Ausführungsform ist die Sensorzeile durch ein Stecker kontaktierbar.

In einer bevorzugten Ausführungsform ist ein Teil der Stützfeldvorrichtung als Element auf dem einzelnen Brückenwiderstand ausgebildet.

Insbesondere bevorzugt wird die erfindungsgemäße Messvorrichtung für das Prüfen von Scheinen oder Bögen, insbesondere von Geldscheinen, Schecks oder anderen Papierbögen auf das Vorhandensein magnetischer Merkmale verwendet, insbesondere daraufhin, ob die Scheine oder Bögen besondere, vorher festgelegte magnetische Merkmale aufweisen. Ein weiteres mögliches Anwendungsgebiet ist die Prüfung ferromagnetischer oder bewegter, elektrisch leitfähiger Objekte auf Unregelmäßigkeiten oder Materialfehler.

Nachfolgend wird die Erfindung anhand von lediglich Ausführungsbeispiele der Erfindung darstellenden Zeichnungen näher erläutert. Darin zeigen:
- Fig. 1:: eine perspektivische Ansicht einer Messvorrichtung zum Messen magnetischer Eigenschaften der Umgebung der Messvorrichtung in einer schematischen Darstellung gemäß einer ersten Ausführungsform;
- Fig. 2:: eine perspektivische Ansicht einer Messvorrichtung zum Messen magnetischer Eigenschaften der Umgebung der Messvorrichtung in einer schematischen Darstellung gemäß einer zweiten Ausführungsform;
- Fig. 3:: eine perspektivische Ansicht der Messvorrichtung gemäß Fig. 2 von unten mit einer ersten Ausführungsform einer Stützfeldvorrichtung zur Erzeugung eines Stützfeldes entlang der Sensorzeile,
- Fig. 4:: eine schematische Seitenansicht der Messvorrichtung gemäß Fig. 3.
- Fig.5:: eine perspektivische Ansicht der Messvorrichtung gemäß Fig. 2 von unten mit einer zweiten Ausführungsform einer Stützfeldvorrichtung zur Erzeugung eines Stützfeldes entlang der Sensorzeile,
- Fig. 6:: eine perspektivische Ansicht der Messvorrichtung gemäß Fig. 2 von unten mit einer dritten Ausführungsform einer Stützfeldvorrichtung zur Erzeugung eines Stützfeldes entlang der Sensorzeile,
- Fig. 7:: eine Seitenansicht einer Messvorrichtung zum Messen magnetischer Eigenschaften der Umgebung der Messvorrichtung in einer schematischen Darstellung gemäß der Ausführungsform aus Fig. 1 in der der Feldlinienverlauf des durch den Vormagnetisiermagneten erzeugten magnetischen Felds dargestellt ist
- Fig. 8:: eine Seitenansicht einer Messvorrichtung zum Messen magnetischer Eigenschaften der Umgebung der Messvorrichtung in einer schematischen Darstellung gemäß der Ausführungsform aus Fig. 2, in der der Feldlinienverlauf des durch den Vormagnetisiermagneten erzeugten magnetischen Felds dargestellt ist
- Fig. 9:: eine perspektivische Ansicht einer Messvorrichtung zum Messen magnetischer Eigenschaften der Umgebung der Messvorrichtung in einer schematischen Darstellung gemäß einer dritten Ausführungsform;
- Fig. 10:: eine perspektivische Ansicht einer Messvorrichtung zum Messen magnetischer Eigenschaften der Umgebung der Messvorrichtung in einer schematischen Darstellung gemäß einer vierten Ausführungsform;
- Fig. 11:: eine perspektivische Ansicht einer Messvorrichtung zum Messen magnetischer Eigenschaften der Umgebung der Messvorrichtung in einer schematischen Darstellung gemäß einer fünften Ausführungsform;
- Fig. 12:: eine Seitenansicht einer Messvorrichtung zum Messen magnetischer Eigenschaften der Umgebung der Messvorrichtung in einer schematischen Darstellung gemäß der Ausführungsform aus Fig. 9, in der der Feldlinienverlauf des gesamten in einer Messsituation im betrachteten y-z-Schnitt wirkenden magnetischen Felds dargestellt ist
- Fig. 13:: eine perspektivische Ansicht des prinzipieller Aufbau eines Sensorelements der Messvorrichtung
- Fig. 14:: eine schematische Ausführungsform der Signalbearbeitung unter Verwendung eines Multiplexers, mehrerer Verstärker, eines Analog-Digital-Wandlers und einer Mikrokontrollereinheit
- Fig. 15:: eine schematische Ausführungsform der Signalbearbeitung unter Verwendung eines Multiplexers, eines Verstärkers, eines Analog-Digital-Wandlers und einer Mikrokontrollereinheit
- Fig. 16:: einen Teil der erfindungsgemäßen Messvorrichtung in einer schematischen Darstellung in einer Aufsicht
- Fig. 17:: einen Aufbau einer Stützfeldvorrichtung einer erfindungsgemäßen Messvorrichtung, bei dem ein Stützfeld erzeugt wird, in einer schematischen Darstellung in Queransicht (oberer Bereich der Fig. 17a) und Längsansicht (oberer Bereich der Fig. 17b) und den jeweils zugehörigen Feldverteilungen entlang der x-Achse (unterer Bereich Fig. 17a) und entlang der y-Achse (unterer Bereich der Fig. 17b)
- Fig. 18:: einen Aufbau einer Stützfeldvorrichtung und einer Vormagnetisierungsvorrichtung einer erfindungsgemäßen Messvorrichtung, bei dem ein auf das Sensorelement lokal begrenztes Stützfelderzeugt wird, in einer schematischen Darstellung in einer Queransicht (oberer Bereich der Fig. 18a) und Längsansicht (oberer Bereich der Fig. 18b) und den jeweils zugehörigen Feldverteilungen entlang der x-Achse (unterer Bereich Fig. 18a) und entlang der y-Achse (unterer Bereich der Fig. 18b).

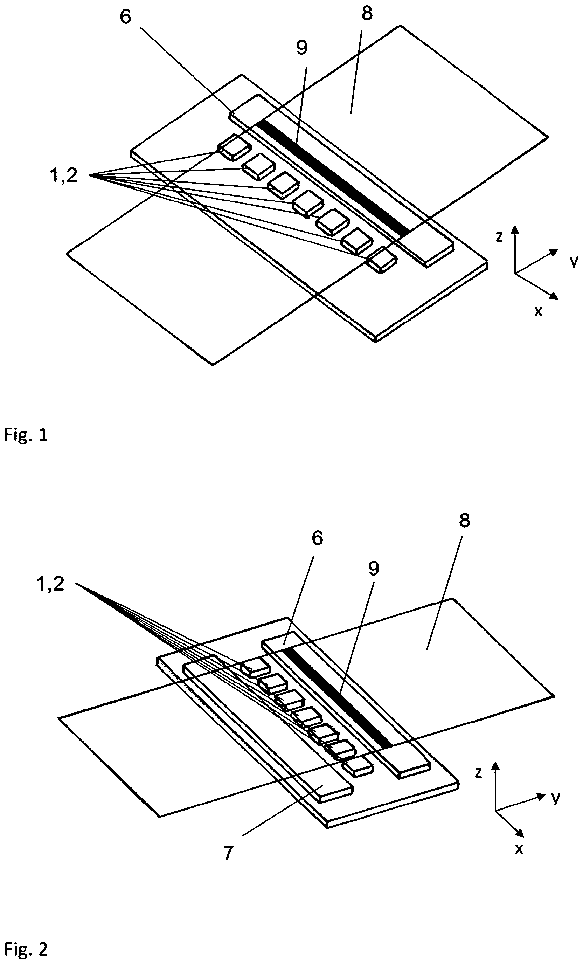

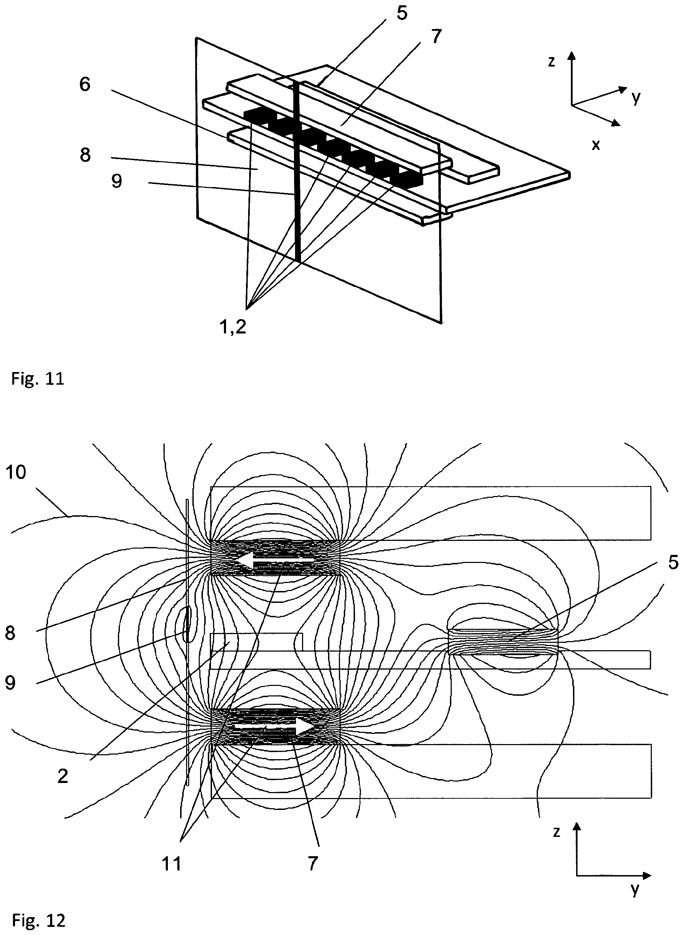

In den Figuren 1 bis 12 werden Ausführungsformen von Messvorrichtungen zum Messen magnetischer Eigenschaften der Umgebung der Messvorrichtung gezeigt, nämlich eine Messvorrichtung zum Prüfen von Scheinen oder Bögen, insbesondere von Geldscheinen, Schecks oder anderen Papierbögen auf das Vorhandensein magnetischer Merkmale, insbesondere daraufhin, ob die Scheine oder Bögen besondere, vorher festgelegten magnetische Merkmale aufweisen.

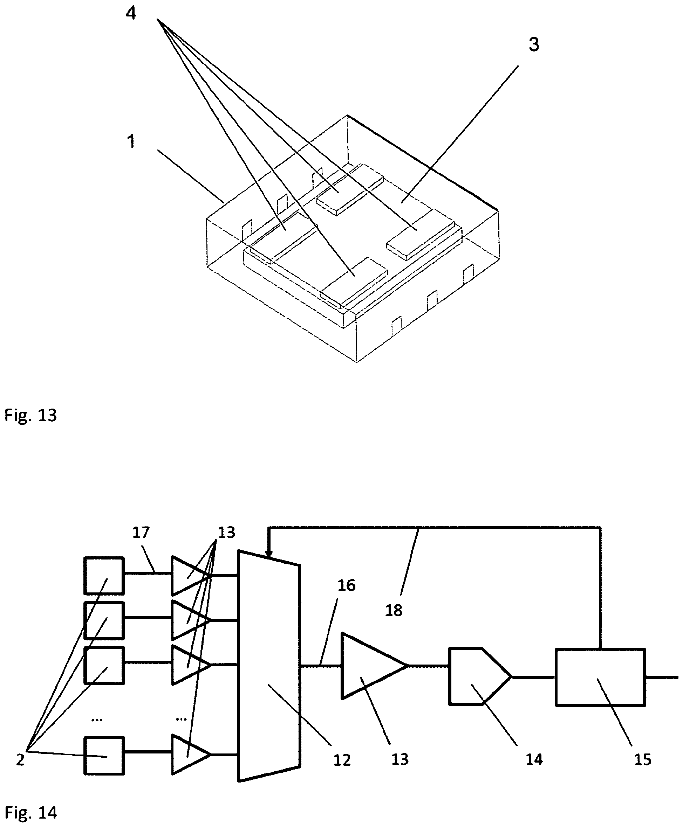

Die in den Figuren 1 bis 12 dargestellten Messvorrichtungen weisen jeweils eine Sensorzeile 2, bestehend aus Sensorelementen 1 auf. Wie in Fig. 13 ersichtlich, weist ein Sensorelement 1 auf einem Substrat 3 aufgebrachte magnetoresistive Brückenwiderstände 4 auf, die zu einer Wheatstone'schen Brücke verschaltet sind. Sofern externe Widerstände verwendet werden, so kann auch ein Brückenwiderstand 4 pro Sensorelement 1 verwendet werden. Die Sensorelemente 1 können in Gruppen zusammengefasst werden, d.h. zu sogenannten Sensoren. Die Brückenwiderstände 4 weisen den AMR-Effekt auf. Mit dieser Brückenschaltung kann das Sensorelement 1 magnetische Eigenschaften seiner Umgebung messen, insbesondere die Änderung der Feldstärke einer Feldkomponente. Die in den Figuren 1 bis 12 dargestellten Sensorzeilen weisen sieben in Zeilenrichtung nebeneinander angeordnete Sensorelemente 1 auf.

Unter einer Wheatstone'schen Brücke kann hier im allgemeinsten Sinne auch eine Anordnung mit Spannungsteilern verstanden werden, deren einzelne Potenziale sowohl zwischen einander als auch relativ zu einer Referenzhalbbrückenspannung ausgewertet werden können.

Die in den Figuren 1 bis 12 dargestellten Messvorrichtungen weisen jeweils eine Stützfeldvorrichtung 5 auf, die in dem Bereich, in dem sich die Sensorzeile 2 erstreckt, ein magnetisches Stützfeld erzeugt.

In den Figuren 1 bis 12 ist ferner ein Wertedokument 8 mit einem Sicherheitsmerkmal 9 dargestellt.

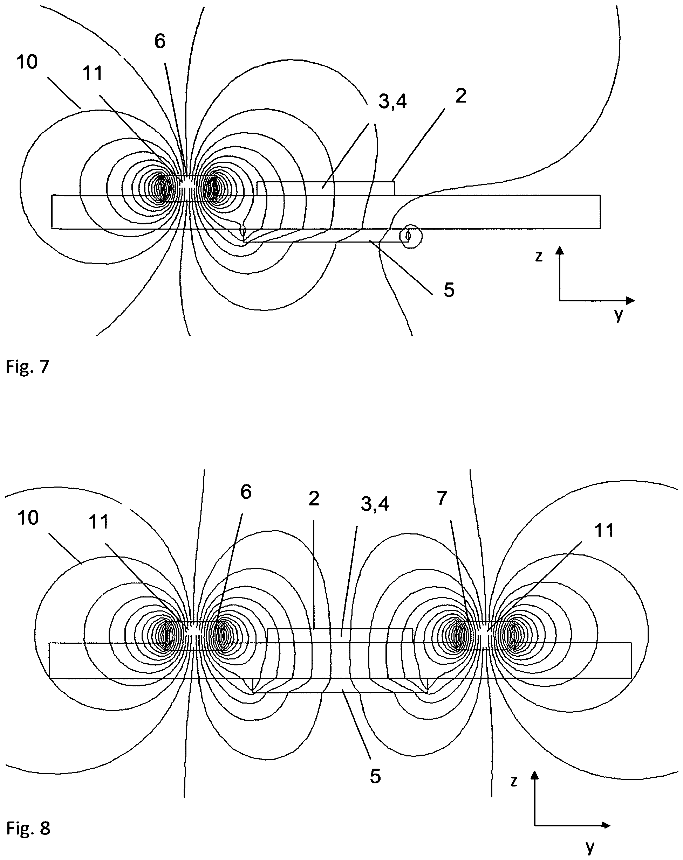

Ferner weisen die in den Figuren 1 bis 12 dargestellten Messvorrichtungen jeweils eine Vormagnetisierungsvorrichtung auf. Bei der in der Figur 1 und 7 dargestellten Ausführungsform weist die Vormagnetisierungsvorrichtung einen Vormagnetisierungsmagneten 6 auf, der in einer zur Zeilenrichtung senkrechten Richtung von der Sensorzeile 2 beabstandet angeordnet ist und sich in einer Richtung parallel zur Zeilenrichtung erstreckt. Die in den Figuren 2 bis 6 und 8 bis 12 dargestellten Ausführungsformen weisen Vormagnetisierungsvorrichtungen auf, die einen ersten Vormagnetisierungsmagneten 6 aufweisen, der in einer zur Zeilenrichtung senkrechten Richtung von der Sensorzeile 2 beabstandet angeordnet ist und sich in einer Richtung parallel zur Zeilenrichtung erstreckt. Ferner weisen die in den Figuren 2 bis 6 und 8 bis 12 dargestellten Ausführungsformen Vormagnetisierungsvorrichtungen mit einem zweiten Vormagnetisierungsmagneten 7 auf, der in einer Richtung von der Sensorzeile 2 beabstandet angeordnet ist, die zu der Richtung, in die der erste Vormagnetisierungsmagnet 6 beabstandet zur Sensorzeile 2 angeordnet ist, entgegengesetzt ist.

Das magnetoresistive Sensorelement 1 misst die magnetischen Eigenschaften seiner Umgebung in der durch die Messrichtung x und Messrichtung y des jeweils in den Figuren dargestellten orthogonalen Koordinatensystems ausgespannten Ebene, nämlich die Änderung der Feldstärke der in Messrichtung y weisenden Feldkomponente des auf das Sensorelement 1 einwirkenden Magnetfeldes. In die Richtung x und Richtung z des in den Figuren 1 bis 12 dargestellten orthogonalen Koordinatensystems kann das magnetoresistive Sensorelement die magnetischen Eigenschaften seiner Umgebung nicht messen.

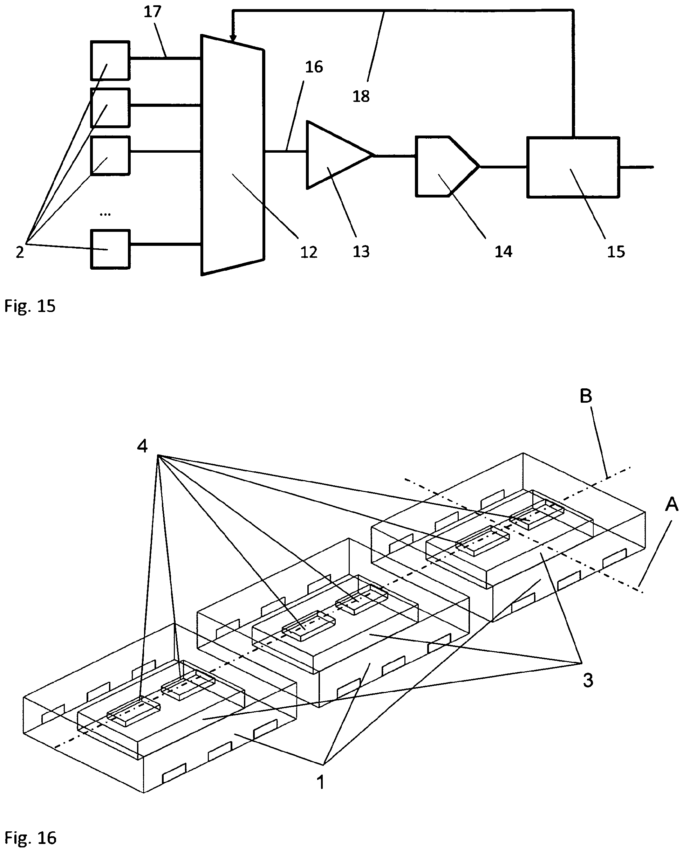

Der in der Figur 1 dargestellte Vormagnetisierungsmagnet 6 der Vormagnetisierungsvorrichtung erzeugt in Richtung der Richtung x und in Richtung y an keiner Stelle der Sensorzeile 2 ein magnetisches Feld dessen Feldstärke in die Richtung x, bzw. Messrichtung y stärker ist, als die Feldstärke des durch die Stützfeldvorrichtung 5 in die Richtung x, bzw. Messrichtung y erzeugten Magnetfelds. Bevorzugt ist der Beitrag für die in Messrichtung y wirkende Komponente von Stützfeldvorrichtung 5 und Vormagnetisierungsvorrichtung möglichst Null. Das ist insbesondere durch die Anordnung des Vormagnetisierungsmagneten 6 relativ zur Sensorzeile 2 bedingt, sowie die Formgebung des Vormagnetisierungsmagneten, der sich in Zeilenrichtung B (x-Richtung, vergleiche auch Fig. 16) entlang der gesamten Sensorzeile 2 erstreckt. Der derart ausgebildete Vormagnetisierungsmagnet 6 erzeugt an jeder Stelle der Sensorzeile 2 ein magnetisches Feld, das im wesentlichen in z-Richtung weist, also in die negative z-Richtung eine Feldstärke aufweist, während die Feldstärke dieses Feldes in die y-Richtung, bzw. in die x-Richtung nahezu 0 ist.

In den Figuren 7, 8 und 12 wird in den Vormagnetisierungsmagneten die Magnetisierungsrichtung des Magneten durch einen Pfeil 11 dargestellt, wobei der Pfeil die Magnetisierungsrichtung vom Südpol zum Nordpol in dem jeweiligen Element darstellt.

In den Figuren 2 bis 6 und in Fig. 8 weist die Vormagnetisierungsvorrichtung einen ersten Vormagnetisierungsmagneten 6 und einen zweiten Vormagnetisierungsmagneten 7 auf. Aufgrund der Anordnung und der geometrischen Erstreckung der Vormagnetisierungsmagneten 6 und 7 weist das durch die Überlagerung der von den Vormagnetisierungsmagneten 6, 7 jeweils einzeln erzeugten magnetischen Felder erzeugte Feld an jeder Stelle der Sensorzeile 2 eine Richtung auf, die im Wesentlichen in die negative z-Richtung weist. Das durch die Überlagerung erzeugte Feld weist somit an keiner Stelle der Sensorzeile eine in x-Richtung oder y-Richtung weisende nennenswerte Feldstärke auf.

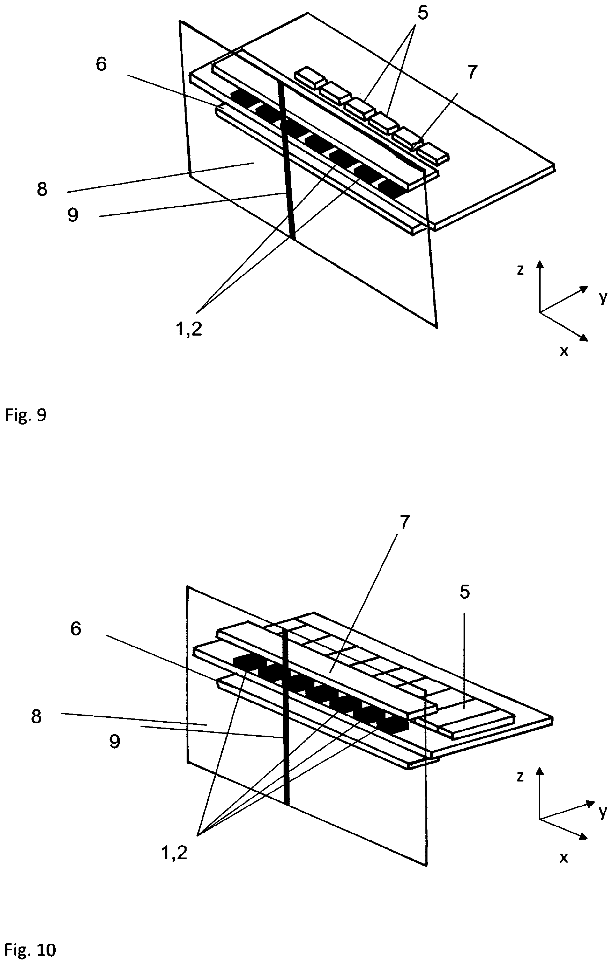

In der Ausführungsform der Fig. 9, 10 und 11 sind die Vormagnetisierungsmagneten 6 und 7 so angeordnet, dass sich die resultierenden Feldkomponentenbeiträge am Ort der Sensorelemente senkrecht zu diesem erstrecken, d.h. in Richtung der Höhe des Sensorelements. Neben der resultierenden Feldkomponente der Vormagnetisierungsmagneten 6 und 7 wirken die Feldkomponenten der Stützfeldvorrichtung 5.

Bei der in Fig. 1 und 7 dargestellten Ausführungsform sind die das von ihm erzeugte magnetische Feld beeinflussenden Eigenschaften des Vormagnetisierungsmagneten 6 und seine Anordnung relativ zur Sensorzeile 2 sowie das von der Stützfeldvorrichtung 5 erzeugte Stützfeld derart gewählt, dass ein Überlagerungsmagnetfeld aus der Überlagerung des von der Vormagnetisierungsvorrichtung erzeugten Magnetfelds und des Stützfelds entsteht, dessen Stärke der in Zeilenrichtung (x-Richtung im Koordinatensystem) weisenden Feldkomponente an allen Orten entlang der Sensorzeile 2 größer ist, als die Stärke der senkrecht zur Zeilenrichtung in Richtung der y-Richtung des Koordinatensystems und damit nicht in Richtung der Höhe des Sensorelements (in z-Richtung des Koordinatensystems) weisenden Feldkomponente.

Bei den in Fig. 2 bis 6 und 8 bis 12 dargestellten Ausführungsformen sind die das von ihnen erzeugte magnetische Feld beeinflussenden Eigenschaften der Vormagnetisierungsmagneten und die Anordnung der Vormagnetisierungsmagneten relativ zur Sensorzeile sowie das von der Stützfeldvorrichtung erzeugte Stützfeld derart gewählt, dass ein Überlagerungsmagnetfeld aus der Überlagerung des von der Vormagnetisierungsvorrichtung erzeugten Magnetfelds und des Stützfelds entsteht, dessen Stärke der in Zeilenrichtung (x-Richtung im Koordinatensystem) weisenden Feldkomponente an allen Orten entlang der Sensorzeile 2 größer ist, als die Stärke der senkrecht zur Zeilenrichtung in Richtung der y-Richtung des Koordinatensystems und damit nicht in Richtung der Höhe des Sensorelements (in z-Richtung des Koordinatensystems) weisenden Feldkomponente.

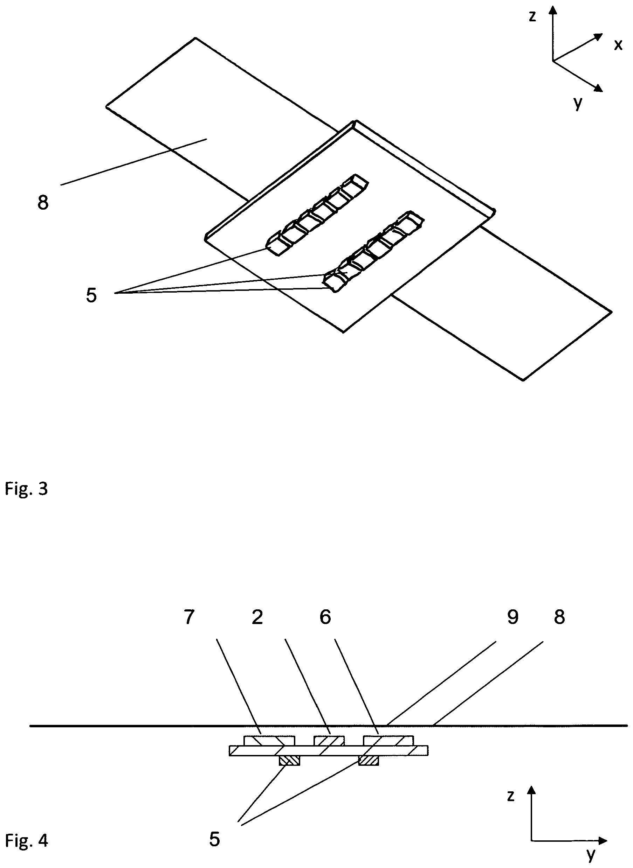

Bei der in Fig. 3 dargestellten Stützfeldvorrichtung wird die Stützfeldvorrichtung durch eine Anordnung permanentmagnetischer Einzelmagneten gebildet. In der in Fig. 5 dargestellten Stützfeldvorrichtung wird die Stützfeldvorrichtung durch einen Polstreifen gebildet. In der in Fig. 6 dargestellten Stützfeldvorrichtung wird die Stützfeldvorrichtung durch einen einzelnen Magneten gebildet.

In der Figur 1 bis 6 und 9 bis 12 ist ein Geldschein 8 mit einem magnetischen Sicherheitsmerkmal 9 dargestellt. Der Geldschein wird senkrecht zur Zeilenrichtung an der Messvorrichtung vorbei bewegt (in den Fig. 1 bis 8 in negative y-Richtung, in den Fig. 9 bis 12 in negative z-Richtung). Dabei wird er zunächst an dem Vormagnetisierungsmagneten 6 vorbei bewegt, der das hartmagnetische Material zunächst vollständig magnetisiert. Danach wird der Geldschein 8 und das hartmagnetische Material 9 weiter bewegt. Das nun magnetisierte hartmagnetische Material erzeugt in seiner Umgebung ein magnetisches Feld. Dieses magnetische Feld überlagert sich im Bereich der Sensorelemente 1 der Sensorzeile 2 dem von der Stützfeldvorrichtung 5 erzeugten magnetischen Feld und dem von der Vormagnetisierungsvorrichtung erzeugten magnetischen Feld in der Sensorzeile. Durch diese Überlagerung des durch das hartmagnetische Material erzeugten magnetischen Feldes auf die dauerhaft bestehenden magnetischen Felder der Stützfeldvorrichtung und der Vormagnetisierungsvorrichtung entsteht eine Änderung des magnetischen Felds in den Sensorelementen 1 der Sensorzeile 2, die durch die magnetoresistiven Sensorelemente 1 festgestellt werden kann. Auf diese Weise kann die Messvorrichtung das Vorhandensein der hartmagnetischen Struktur 9 auf dem Geldschein 8 feststellen. Weist der Geldschein 8 zusätzlich weichmagnetische Strukturen auf, so werden diese weichmagnetischen Strukturen durch das Magnetfeld des Vormagnetisierungsmagneten / der Vormagnetisierungsmagneten im Idealfall vollständig gesättigt und zwar insbesondere in dem Bereich der Messvorrichtung, wenn sich die weichmagnetische Struktur in der Nähe der Sensorzeile 2 befindet. Dann überlagert sich das durch die gesättigte, weichmagnetische Struktur erzeugte magnetische Feld zusätzlich mit dem durch das hartmagnetische Material erzeugten magnetischen Feld und den dauerhaft bestehenden magnetischen Feldern der Stützvorrichtung und der Vormagnetisierungsvorrichtung, wodurch eine Änderung des magnetischen Feldes in den Sensorelementen 1 der Sensorzeile 2 entsteht, die durch die magnetoresistiven Sensorelemente 1 festgestellt werden kann.

Figur 14 zeigt eine schematische Ausführungsform der Signalbearbeitung. Jedes Sensorelement 2 liefert ein Sensorsignal, dass über eine Signalleitung 17 einem Verstärker 13 zugeführt wird, dessen Ausgangssignal auf einen Multiplexer 12 gegeben wird. Die verstärkten Sensorsignale werden durch den Multiplexer 12 in zeitlicher Folge auf eine Ausgangssignalleitung 16 zusammengefasst. Das Signal der Ausgangssignalleitung wird dann in einer zweiten Verstärkerstufe 13 verstärkt oder unverstärkt zur Digitalisierung einem A/D-Wandler 14 zugeführt und in einer Mikrokontrollereinheit 15 verarbeitet. Die Mikrokontrollereinheit 15 steuert über eine Steuerleitung 18 den Multiplexer 12.

Figur 15 zeigt eine weitere Ausführungsform der Signalbearbeitung. Jedes Sensorsignal eines Sensorelements 2 wird über eine Signalleitung 17 unverstärkt auf einen Multiplexer 12 gegeben wird. Die unverstärkten Sensorsignale werden durch den Multiplexer 12 in zeitlicher Folge auf eine Ausgangssignalleitung 16 zusammengefasst. Das Signal der Ausgangssignalleitung wird dann in einer Verstärkerstufe 13 verstärkt und zur Digitalisierung einem A/D-Wandler 14 zugeführt und in einer Mikrokontrollereinheit 15 verarbeitet. Die Mikrokontrollereinheit 15 steuert über eine Steuerleitung 18 den Multiplexer 12.

In Fig. 16 sind Sensorelemente 1 gezeigt, die entlang der x-Achse angeordnet sind. Die Linie B verläuft parallel zur x-Achse und durch die Sensormessebene. Die Linie A verläuft senkrecht zur Linie B entlang der y-Richtung durch die Sensormessebene.

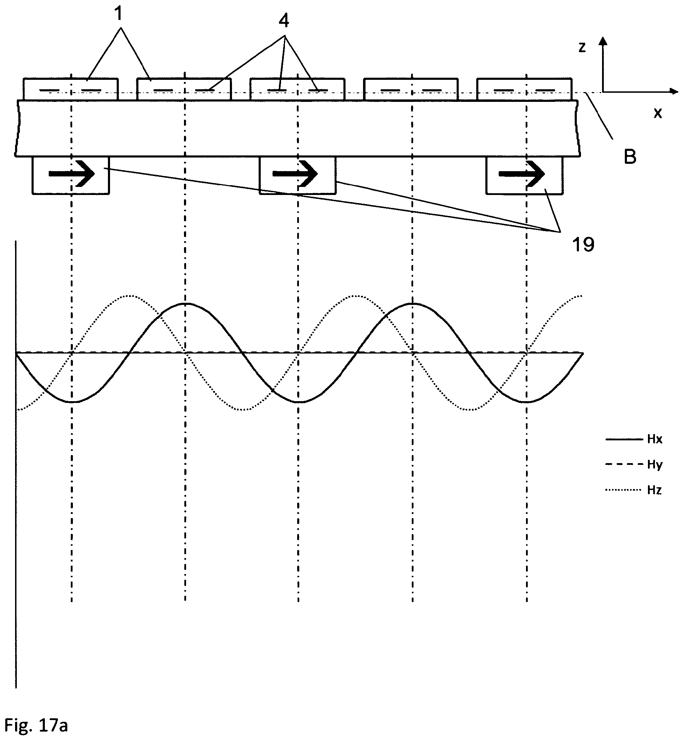

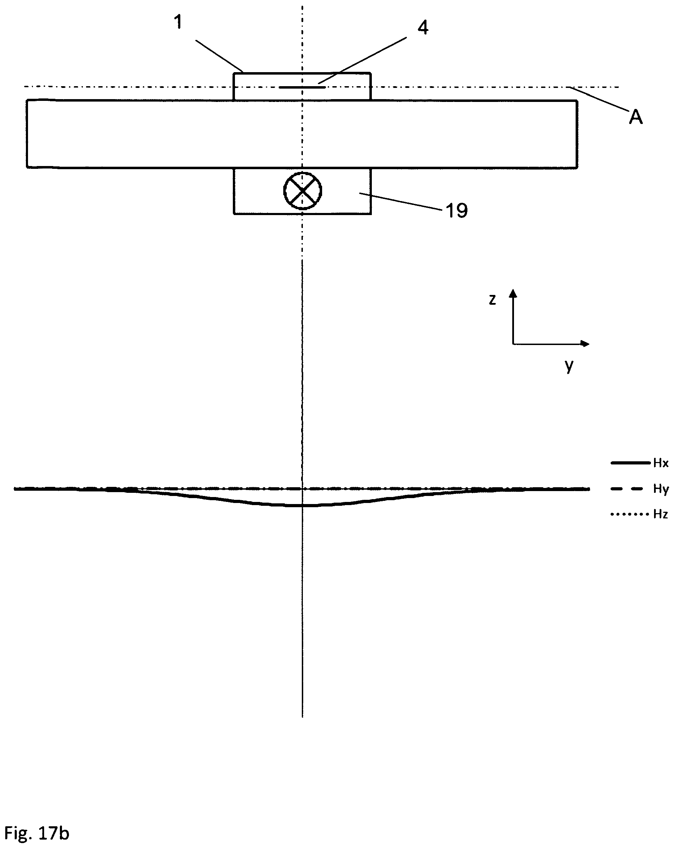

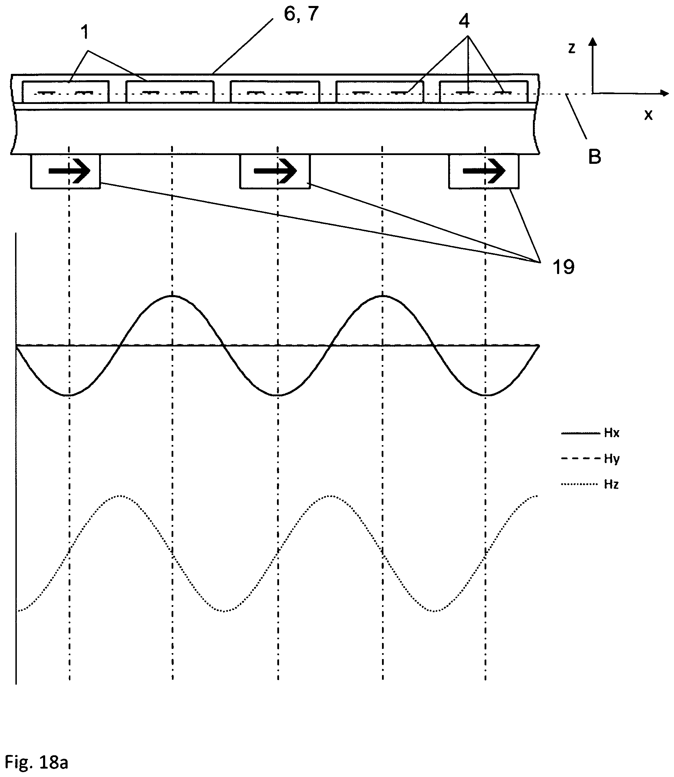

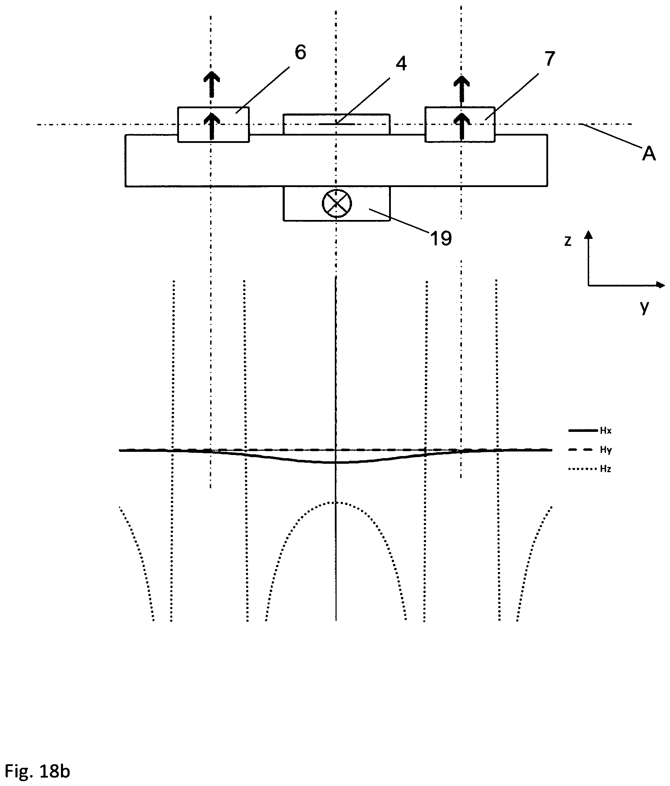

Die Länge der Sensorzeile und damit die Zeile der magnetoresistiven Sensorelemente 1 hängt von der durchzuführenden Messung ab. Insbesondere hängt die Anzahl der verwendeten Sensorelemente 1 von der Messaufgabe ab, also im wesentlichen von der Breite des zu vermessenden Objekts. Zur Messung von Euro-Banknoten kann eine Sensorzeile beispielsweise mehr als 10, insbesondere bevorzugt mehr als 20, vor allem 28 Sensorelemente 1 aufweisen, insbesondere bevorzugt mehr als 100 Sensorelemente 1, bspw. 168, aufweisen.
Der Verlauf von Magnetfeldkomponenten für eine Messvorrichtung wird nun anhand der Fig. 17 und 18 veranschaulicht. Dazu ist in Fig. 17 und 18 eine mögliche Bauform einer Stützfeldvorrichtung 5, wie sie beispielsweise auch in der Fig. 8 wiedergegeben ist, dargestellt. Mit der Stützfeldvorrichtung 5 kann ein Magnetfeld erzeugt werden, das eine in Zeilenrichtung weisende Magnetfeldkomponente aufweist, deren Feldstärke in der Sensorzeile 2 in Zeilenrichtung variiert.

Fig. 18 zeigt eine bevorzugte Ausführungsform einer Sensorzeile 2, in der die in den Fig. 17 gezeigte Stützfeldvorrichtung 5 zusammen mit einer Vormagnetisierungsvorrichtung, die Vormagnetisierungsmagneten 6 und 7 aufweist, Anwendung findet.

Die Fig. 17a zeigt im oberen Bereich entlang der Linie B angeordnete Sensorelemente 1, die einen Abschnitt einer Sensorzeile 2, die von links nach rechts verläuft, bilden. Die Fig. 17b zeigt im oberen Bereich den zugehörigen Längsschnitt entsprechend dem oberen Bereich der Fig. 17a.

Die Stützfeldvorrichtung 5 in Fig. 17 weist mehrere (Stützfeld-)Magnete 19 auf, die unterhalb der Sensorelemente 1 angeordnet sind. Dies bedeutet, dass das Messobjekt, beispielsweise das Wertdokument 8, oberhalb der in Fig. 17 dargestellten Sensorzeile geführt wird, und die Magnete 19 der Stützfeldvorrichtung auf der entgegen gesetzten Seite, d.h. unterhalb der Sensorzeile, abgeordnet sind. Die Sensorelemente 1 weisen mindestens einen Brückenwiderstand 4 auf.

In der in Fig. 17 dargestellten Stützfeldvorrichtung 5 sind die Magnete 19 gleich ausgerichtet. Der jeweilige Nordpol der Magnete 19 weist nach rechts, welches durch die Pfeile in den jeweiligen Magneten 19 veranschaulicht ist.

Die durch die Anordnung der Stützfeldmagnete 19 erzeugte Magnetfeldverteilung ist im jeweils unteren Bereich der Fig. 17a und 17b dargestellt.

Figur 17a zeigt im unteren Bereich die beiden Feldkomponenten der Stützfeldvorrichtung 5 entlang der x- und der z-Richtungen, die einen sinusartigen, phasenverschobenen Verlauf zeigen. Die Feldkomponente der Stützfeldvorrichtung 5 in y-Richtung ist Null.

Figur 17b zeigt die Feldverteilung für die Stützfeldvorrichtung 5 im Längsschnitt.entlang der Linie A. Die Stützfeldkomponente Hx zeigt eine Abhängigkeit entlang der y-Richtung, während die beiden anderen Komponenten Null sind.

In Fig. 18 ist nun die in der Fig. 17 dargestellte Stützfeldvorrichtung 5 um die Vormagnetisierungsvorrichtung, wie sie in den Figuren 1 bis 8 beschrieben ist, und Vormagnetisierungsmagneten 6 und 7 aufweisen kann, ergänzt. Fig. 18a zeigt im oberen Bereich den Querschnitt. Die beiden Vormagnetisierungsmagneten 6, 7 sind symmetrisch links und rechts vom Sensorelement 1 angeordnet (siehe auch Fig. 18b). Die Stützfeldmagneten 19 sind unterhalb des Sensorelements 1 angeordnet.

Im unteren Bereich der Fig. 18a ist schematisch die zugehörige Verteilung der Feldkomponenten gezeigt. Die Verteilung der Hx- und der Hy-Komponenten des Überlagerungsfeldes aus Magnetfeld der Stützfeldvorrichtung 5 und Magnetfeld der Vormagnetisierungsvorrichtung entspricht im Wesentlichen der Verteilung der Hx- und der Hy-Komponenten des Magnetfelds der Stützfeldvorrichtung 5 alleine, während die Hz-Komponente der Stützfeldvorrichtung durch den Beitrag der Vormagnetisierungsmagneten 6, 7 überlagert wird. Die Beeinflussung der Hx- und der Hy-Komponente des Überlagerungsfeldes ist gering bzw. es liegt ungefähr keine Beeinflussung vor.

Fig. 18b zeigt im oberen Bereich den zugehörigen Längsschnitt zur Fig. 18a. Im unteren Bereich der Fig. 18b ist das Überlagerungsfeld dargestellt. Die Feldkomponente Hz des Überlagerungsfeldes zeigt einen komplexen Verlauf entlang der Linie A. Über den Vormagnetisiermagneten 6, 7 ist der Wert sehr groß (positiv). Über dem Sensorelement 1 findet sich ein großer negativer Wert. Der Verlauf der Feldkomponente in x-Richtung ist im Wesentlichen unbeeinflusst von dem zusätzlichen Feldbeitrag der Vormagnetisiermagneten 6, 7 und zeigt annähernd den gleichen Verlauf wie in Figur 17a.

In den Figuren 17 und 18 erkennt man, dass der Feldstärkeverlauf in Zeilenrichtung B im Bereich der Ränder der Sensorelemente 1 weder einen Nulldurchgang noch ein Maximum oder Minimum aufweist. Bei der in den Fig. 17 und 18 gezeigten Ausführungsform weist der Feldstärkeverlauf in der Mitte eines Sensorelements 1 ein Maximum, bzw. ein Minimum auf und zwischen zwei Sensorelementen 1 einen Nulldurchgang.

Aus dem Verlauf der Magnetfeldkomponenten für die Anordnung der Fig. 17 und 18 lassen sich auch Aussagen über eine Messvorrichtung treffen, die einen Vormagnetisierungsmagneten 6 wie in Fig. 1 aufweist. Der in Fig. 1 dargestellte Vormagnetisierungsmagnet 6 erzeugt an jeder Stelle der Sensorzeile 2 ein magnetisches Feld, das im Wesentlichen in z-Richtung weist, also in die negative z-Richtung eine Feldstärke aufweist, während die Feldstärke dieses Feldes in die y-Richtung, bzw. in die x-Richtung nahezu 0 ist. Kombiniert man den in Fig. 1 dargestellten Aufbau der Vormagnetisierungsvorrichtung mit einer Stützfeldvorrichtung, wie sie im Zusammenhang mit den Fig. 17 und 18 beschrieben wurde, so erkennt man, dass die Stützfeldvorrichtung 5 ein Magnetfeld erzeugt, bei dem die Feldstärke der in x-Richtung (in Zeilenrichtung) weisenden Feldkomponente zwischen einem positiven Maximalwert und einem negativen Maximalwert schwankt. In den Punkten, in denen auch bei der Stützfeldvorrichtung 5 die in Zeilenrichtung (x-Richtung) weisende Feldkomponente den Wert 0 annimmt, entspricht der Wert der in Zeilenrichtung weisenden Feldkomponente dem Wert der entsprechenden in Zeilenrichtung weisenden Feldkomponente der Vormagnetisierungsvorrichtung - beide Komponenten nehmen nämlich den Wert 0 an. Man erkennt aber auch aus dem in den Fig. 17 und 18 dargestellten Verlauf, dass die von der Stützfeldvorrichtung 5 erzeugte Feldkomponente in Zeilenrichtung auch Werte größer, bzw. kleiner 0 aufweist. Die Feldstärke der in Zeilenrichtung weisenden Feldkomponente des Überlagerungsmagnetfelds entspricht somit der Feldstärke der durch die Stützfeldvorrichtung erzeugten Feldkomponente in diese Richtung. Der Beitrag des durch die Vormagnetisierungsvorrichtung erzeugten Feldes in diese Richtung ist 0. Ebenso ist der Beitrag der in y-Richtung weisenden Feldstärke der Vormagnetisierungsvorrichtung in diese Richtung 0.

## Patentansprüche

1. Messvorrichtung zum Messen magnetischer Eigenschaften der Umgebung der Messvorrichtung mit einer Sensorzeile (2) mit mindestens einem sich in eine Zeilenrichtung erstreckenden magnetoresistiven Sensorelement (1), das magnetische Eigenschaften in seiner Umgebung messen kann, wobei das Sensorelement (1) eine Breite und eine Länge sowie eine Höhe aufweist, wobei die Höhe geringer ist als die Breite und die Höhe geringer ist als die Länge und die Zeilenrichtung in Richtung der Breite oder in Richtung der Länge des Sensorelements (1) weist und mit einer Stützfeldvorrichtung (5), die in dem Bereich, über den sich die Sensorzeile (2) erstreckt, ein magnetisches Stützfeld erzeugt, sowie mit einer Vormagnetisierungsvorrichtung, die einen Vormagnetisierungsmagneten (6) oder mehrere Vormagnetisierungsmagneten (6, 7) aufweist, wobei zumindest ein Vormagnetisierungsmagnet (6, 7) in einer zur Zeilenrichtung senkrechten Richtung von der Sensorzeile (2) beabstandet angeordnet ist und sich in einer Richtung parallel zur Zeilenrichtung erstreckt, **dadurch gekennzeichnet, dass**
- das magnetoresistive Sensorelement (1) im Wesentlichen nur in einer als Messrichtung bezeichneten Richtung eines orthogonalen Koordinatensystems oder Im Wesentlichen nur in einer als Sensormessebene bezeichneten, durch zwei senkrechte Messrichtungen eines orthogonalen Koordinatensystems aufgespannten Ebene die magnetischen Eigenschaften seiner Umgebung messen kann,
- bei einer nur aus einem Vormagnetisierungsmagneten (6) bestehenden Vormagnetisierungsvorrichtung die das von Ihm erzeugte magnetische Feld beeinflussenden Eigenschaften des Vormagnetisierungsmagneten (6) und seine Anordnung relativ zur Sensorzeile (2) sowie das von der Stützfeldvorrichtung (5) erzeugte Stützfeld derart gewählt sind, dass ein Überlagerungsmagnetfeld aus der Überlagerung des von der Vormagnetisierungsvorrichtung erzeugten Magnetfelds und des Stützfelds entsteht, dessen Stärke der in Zeilenrichtung weisenden Feldkomponente zumindest an einem Ort auf der Sensorzeile (2) größer ist als die Stärke der senkrecht zur Zellenrichtung und nicht in Richtung der Höhe des Sensorelements (1) weisenden Feldkomponente, oder
- bei einer aus mehreren Vormagnetisierungsmagneten (6, 7) bestehenden Vormagnetisierungsvorrichtung die das von ihnen erzeugte magnetische Feld beeinflussenden Eigenschaften der Vormagnetisierungsmagneten (6, 7) und die Anordnung der Vormagnetisierungsmagneten (6, 7) relativ zur Sensorzeile (2) sowie das von der Stützfeldvorrichtung (5) erzeugte Stützfeld derart gewählt sind, dass ein Überlagerungsmagnetfeld aus der Überlagerung des von der Vormagnetisierungsvorrichtung erzeugten Magnetfelds und des Stützfelds entsteht, dessen Stärke der in Zeilenrichtung weisenden Feldkomponente zumindest an einem Ort auf der Sensorzeile (2) größer ist als die Stärke der senkrecht zur Zeilenrichtung und nicht In Richtung der Höhe des Sensorelements (2) weisenden Feldkomponente.

2. Messvorrichtung nach einem der Ansprüche 1, **dadurch gekennzeichnet, dass** die Vormagnetisierungsvorrichtung einen ersten Vormagnetisierungsmagneten (6) und einen zweiten Vormagnetisierungsmagneten (7) aufweist, wobei der zweite Vormagnetisierungsmagnet (7) in einer Richtung von der Sensorzeile (2) beabstandet angeordnet ist, die zu der Richtung, in die der erste Vormagnetisierungsmagnet (6) beabstandet zur Sensorzeile (2) angeordnet ist, entgegengesetzt Ist.

3. Messvorrichtung nach Anspruch 1 oder 2, **dadurch gekennzeichnet, dass** die Sensorzeile (2) und die Stützfeldvorrichtung (5) auf einer Leiterplatte angeordnet sind.

4. Messvorrichtung nach einem der Ansprüche 1 bis 3, **dadurch gekennzeichnet, dass** die Sensorzeile (2), die Stützfeldvorrichtung (5) und zumindest ein Vormagnetisierungsmagnet (6, 7) der Vormagnetisierungsvorrichtung auf einer Leiterplatte angeordnet sind.

5. Messvorrichtung nach einem der Ansprüche 1 bis 4, **dadurch gekennzeichnet, dass** die Stützfeldvorrichtung (5) eine permanentmagnetische Schicht aufweist, bei der die in eine Richtung senkrecht zur Zeilenrichtung weisende Dicke kleiner ist, als eine In eine zweite Richtung senkrecht zur Zeilenrichtung weisende Breite.

6. Messvorrichtung nach Anspruch 5, **dadurch gekennzeichnet, dass** die Stützfeldvorrichtung (5) eine periodische Magnetisierung aufweist.

7. Messvorrichtung nach einem der Ansprüche 1 bis 6, **dadurch gekennzeichnet, dass** die Stützfeldvorrichtung (5) eine Anordnung permanentmagnetischer Magnete aufweist, die eine gemeinsame Magnetisierungsrichtung aufweisen oder dass die Stützfeldvorrichtung eine Anordnung permanentmagnetischer Magnete aufweist, die eine alternierende Magnetisierungsrichtung aufweisen.

8. Messvorrichtung nach einem der Ansprüche 1 bis 7, **dadurch gekennzeichnet, dass** die Sensorzeile (2) mindestens zwei Sensorelemente (1) aufweist, dass jedes Sensorelement (1) mindestens eine Signalleitung aufweist, über die das Sensorelement (1) ein Sensorsignal abgibt, und zumindest ein Multiplexer (12) vorgesehen ist, dem zumindest ein Teil der Signalleitungen der Sensorelemente (1) zugeführt wird und der die Sensorsignale der ihm zugeführten Signalleitungen unvermittelbar oder vorverstärkt so bearbeitet, dass ein einziges Signal an einer Ausgangssignalleitung des Multiplexers (12) ausgegeben werden kann, das auf Grundlage der Sensorsignale der Signalleitungen erzeugt wurde.

9. Messvorrichtung nach Anspruch 8, **dadurch gekennzeichnet, dass** für mindestens eine Signalleitung ein Verstärker (13) vorgesehen ist, der das Sensorsignal verstärkt.

## Claims

1. Measuring device for measuring magnetic properties of the surroundings of the measuring device having a sensor line (2) comprising at least one magnetoresistive sensor element extending in a line direction (1), which can measure magnetic properties in its surroundings, wherein the sensor element (1) has a width and a length as well as a height, wherein the height is less than the width and the height is less than the length and the line direction points in a direction of the width or in a direction of the length of the sensor element (1) and, with a support field device (5), which generates a magnetic support field in an area, over which the sensor line (2) extends, and with a pre-magnetization device, having a pre-magnetization magnet (6) or multiple pre-magnetization magnets (6, 7), wherein at least one pre-magnetization magnet (6, 7) is arranged some distance away from the sensor line (2) in a direction that is vertical to the line and that extends in a direction parallel to the line direction, **characterized in that**
- the magnetoresistive sensor element (1) essentially only measures the magnetic properties of the magnetoresistive sensor element's surroundings in one direction designated as a measuring direction of an orthogonal coordinate system or in one plane designated as a sensor measuring plane, spanned by two vertical measuring directions of an orthogonal coordinate system,
- with a pre-magnetization device only composed of one pre-magnetization magnet (6) the properties influencing a magnetic field generated by it of the pre-magnetization magnet (6) and its arrangement relative to the sensor line (2) as well as the support field generated by the support field device (5) are selected such that an overlapping magnetic field results from overlapping of the magnetic field and the support field generated by the pre-magnetization device whose strength of the component pointing in the line direction is greater, at least at one location on the sensor line (2), than the strength of a field component pointing vertically toward the line direction and not in the direction of the height of the sensor element (1); or
- with a pre-magnetization device composed of multiple pre-magnetization magnets (6, 7) the properties, influencing the magnetic field generated by the pre-magnetization magnets (6, 7) and the arrangement of the pre-magnetization magnets (6, 7) relative to the sensor line (2) as well as the support field generated by the support field device (5) are selected such that an overlapping magnetic field results from an overlapping of the magnetic field and the support field generated by the pre-magnetization device whose strength of the field component pointing in the line direction is greater, at least at one location on the sensor line (2), than the strength of a field component pointing vertically toward the line direction and not in the direction of the height of the sensor element (2).

2. Measuring device according to claim 1, **characterized in that** the pre-magnetization device has a first pre-magnetization magnet (6) and a second pre-magnetization magnet (7), wherein the second pre-magnetization magnet (7) is arranged some distance away from the sensor line (2), in a direction, that is opposite the direction in which the first pre-magnetization magnet (6) is arranged some distance away from the sensor line (2).

3. Measuring device according to claims 1 or 2, **characterized in that** the sensor line (2) and the support field device (5) are arranged on a printed circuit board.

4. Measuring device according to any one of claims 1 to 3, **characterized in that** the sensor line (2), the support field device (5) and at least one pre-magnetization magnet (6, 7) of the pre-magnetization device are arranged on a printed circuit board.

5. Measuring device according to any one of claims 1 to 4, **characterized in that** the support field device (5) has a permanent magnetic layer, in which the thickness pointing in a direction vertical with respect to the line direction is less than a width in a second direction vertical with respect to the line direction.

6. Measuring device according to claim 5, **characterized in that** the support field device (5) has periodic magnetization.

7. Measuring device according to any one of claims 1 to 6, **characterized in that** the support field device (5) has an arrangement of permanent magnetic magnets, that have a common magnetization direction or that the support field device has an arrangement of permanent magnetic magnets which have an alternating direction of magnetization.

8. Measuring device according to any one of claims 1 to 7, **characterized in that** the sensor line (2) has at least two sensor elements (1), that each sensor element (1) has at least one signal line, via which the sensor element (1) emits a sensor signal, and at least one multiplexer (12) is provided, to which at least a portion of the signal lines of the sensor elements (1) is routed and that processes the sensor signals of the signal lines routed to it, directly or pre-amplified, such that a single signal can be provided to an output signal line of the multiplexer (12), which was generated based on the sensor signals of the signal lines.

9. Measuring device according to claim 8, **characterized in that** an amplifier (13), which amplifies the sensor signal, is provided for at least one signal line.

## Revendications

1. Dispositif de mesure pour mesurer des propriétés magnétiques de l'environnement du dispositif de mesure avec une ligne de détecteurs (2) comprenant au moins un élément de détection magnéto-résistif (1) qui s'étend dans une direction de ligne et est capable de mesurer des propriétés magnétiques dans son environnement, l'élément de détection (1) ayant une largeur, une longueur et une hauteur telles que la hauteur est inférieure à la largeur et la hauteur est inférieure à la longueur, et la direction de ligne étant orientée dans le sens de la largeur ou dans le sens de la longueur de l'élément de détection (1), et avec un dispositif de production de champ de support (5) qui produit un champ magnétique de support dans la zone au-dessus de laquelle s'étend la ligne de détecteurs (2), et avec un dispositif de pré-magnétisation qui présente un aimant de pré-magnétisation (6) ou plusieurs aimants de pré-magnétisation (6, 7), au moins un aimant de pré-magnétisation (6, 7) étant disposé à distance de la ligne de détecteurs (2) dans une direction perpendiculaire à la direction de ligne et s'étendant dans une direction parallèle à la direction de ligne, **caractérisé en ce que**
- l'élément de détection magnéto-résistif (1) est capable de mesurer les propriétés magnétiques de son environnement sensiblement uniquement dans une direction d'un système de coordonnées orthogonal, désignée comme direction de mesure, ou sensiblement uniquement dans un plan défini par deux directions de mesure perpendiculaires d'un système de coordonnées orthogonal, désigné comme plan de mesure de détecteur,
- avec un dispositif de pré-magnétisation se composant d'un seul aimant de pré-magnétisation (6), les propriétés de l'aimant de pré-magnétisation (6) qui agissent sur le champ magnétique qu'il produit, et son agencement par rapport à la ligne de détecteurs (2), ainsi que le champ de support produit par le dispositif de production de champ de support (5) sont sélectionnés de sorte qu'un champ magnétique de superposition est formé par superposition du champ magnétique produit par le dispositif de pré-magnétisation, et du champ de support, dont l'intensité de la composante de champ orientée dans la direction de ligne, au moins en un emplacement de la ligne de détecteurs (2), est supérieure à l'intensité de la composante de champ orientée perpendiculairement à la direction de ligne et non dans la direction de la hauteur de l'élément de détection (1), ou
- avec un dispositif de pré-magnétisation se composant de plusieurs aimants de pré-magnétisation (6, 7), les propriétés des aimants de pré-magnétisation (6, 7) qui agissent sur le champ magnétique qu'ils produisent, et l'agencement des aimants de pré-magnétisation (6, 7) par rapport à la ligne de détecteurs (2), ainsi que le champ de support produit par le dispositif de production de champ de support (5) sont sélectionnés de sorte qu'un champ magnétique de superposition est formé par superposition du champ magnétique produit par le dispositif de pré-magnétisation, et du champ de support, dont l'intensité de la composante de champ orientée dans la direction de ligne, au moins en un emplacement de la ligne de détecteurs (2), est supérieure à l'intensité de la composante de champ orientée perpendiculairement à la direction de ligne et non dans la direction de la hauteur de l'élément de détection (2).

2. Dispositif de mesure selon la revendication 1, **caractérisé en ce que** le dispositif de pré-magnétisation présente un premier aimant de pré-magnétisation (6) et un second aimant de pré-magnétisation (7), le second aimant de pré-magnétisation (7) étant disposé à distance de la ligne de détecteurs (2) dans une direction qui est opposée à la direction dans laquelle le premier aimant de pré-magnétisation (6) est disposé à distance par rapport à la ligne de détecteurs (2).

3. Dispositif de mesure selon la revendication 1 ou 2, **caractérisé en ce que** la ligne de détecteurs (2) et le dispositif de production de champ de support (5) sont disposés sur un circuit imprimé.

4. Dispositif de mesure selon l'une quelconque des revendications 1 à 3, **caractérisé en ce que** la ligne de détecteurs (2), le dispositif de production de champ de support (5) et au moins un aimant de pré-magnétisation (6, 7) du dispositif de pré-magnétisation sont disposés sur un circuit imprimé.

5. Dispositif de mesure selon l'une quelconque des revendications 1 à 4, **caractérisé en ce que** le dispositif de production de champ de support (5) présente une couche magnétique permanente dont l'épaisseur orientée dans une direction perpendiculairement à la direction de ligne est inférieure à l'épaisseur orientée dans une seconde direction perpendiculairement à la direction de ligne.

6. Dispositif de mesure selon la revendication 5, **caractérisé en ce que** le dispositif de production de champ de support (5) présente une magnétisation périodique.

7. Dispositif de mesure selon l'une quelconque des revendications 1 à 6, **caractérisé en ce que** le dispositif de production de champ de support (5) présente un agencement d'aimants magnétiques permanents qui présentent une direction de magnétisation commune ou que le dispositif de production de champ de support présente un agencement d'aimants magnétiques permanents qui présentent une direction de magnétisation alternante.

8. Dispositif de mesure selon l'une quelconque des revendications 1 à 7, **caractérisé en ce que** la ligne de détecteurs (2) présente au moins deux éléments de détection (1), que chaque élément de détection (1) présente au moins une ligne de signaux, par laquelle l'élément de détection (1) émet un signal de détecteur, et au moins un multiplexeur (12) est prévu, auquel au moins une partie des lignes de signaux des éléments de détection (1) est adressée et qui traite les signaux de détecteur des lignes de signaux qui lui sont adressés de manière intransmissible ou préamplifiée de telle sorte qu'un seul signal puisse être émis à une ligne de signaux de sortie du multiplexeur (12), ledit signal ayant été généré suite aux signaux de détecteur des lignes de signaux.

9. Dispositif de mesure selon la revendication 8, **caractérisé en ce qu'**un amplificateur (13), qui amplifie le signal de détecteur, est prévu pour au moins une ligne de signaux.
